# EUROPEAN PATENT APPLICATION

(11) **EP 4 712 139 A1**
(43) Date of publication of application: **18.03.2026**
(21) Application number: 25164883.8
(22) Date of filing: 19.03.2025
(51) Int. Cl.: H01L 23/482

(54) **SEMICONDUCTOR DEVICE WITH GATE CONTACT REGION FORMED IN PARTIAL REGION OF GATE RUNNER**

(30) Priority: 12.09.2024 KR 20240124677
(71) Applicant: Samsung Electronics Co., Ltd., Suwon-si, Gyeonggi-do 16677 (KR)
(72) Inventor: KIM, Taehun, Suwon-si (KR); PARK, Jeonghwan, Suwon-si (KR); KO, Mingu, Suwon-si (KR); PARK, Young Hwan, Suwon-si (KR); OH, Sewoong, Suwon-si (KR); WOO, Sangsu, Suwon-si (KR)
(74) Representative: Marks & Clerk LLP

(57) **Abstract**

A semiconductor device includes: a substrate including (i) a first active region comprising a plurality of unit cells, and (ii) a peripheral area surrounding at least a portion of the first active region; a gate frame comprising (i) a first portion in a wiring region and extending along a first direction, (ii) a second portion extending from one side of the first portion along a second direction crossing the first direction and connected to a first end of at least a portion among the plurality of unit cells, and (iii) a third portion extending from the first side along the second direction and connected to a second end of at least a portion among the plurality of unit cells; a first gate runner on the first portion of the gate frame and the second portion of the gate frame; and a second gate runner on the third portion.

## Description

### BACKGROUND

The present disclosure relates to a semiconductor device having a gate contact region formed in a partial region of a gate runner.

In modern society, semiconductor devices are closely related to daily life. In particular, the importance of power semiconductor devices used in various fields such as transportation fields such as electric vehicles, railroads, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, thereby enabling power semiconductor devices to handle large amounts of current and withstand high voltage. For example, power semiconductor devices can handle voltages from hundreds of volts to thousands of volts and currents from tens of amperes to thousands of amperes. Power semiconductor devices can improve the efficiency of electrical energy by minimizing power loss. Additionally, power semiconductor devices can be stably driven even in environments such as high temperatures.

These power semiconductor devices may be classified according to materials, and examples include SiC power semiconductor devices and GaN power semiconductor devices. By manufacturing power semiconductor devices using SiC or GaN instead of existing silicon wafers, the disadvantage of silicon, which has unstable characteristics at high temperatures, can be compensated. SiC power semiconductor devices are resistant to high temperatures and have low power loss, and can be suitable for electric vehicles, renewable energy systems, etc. GaN power semiconductor devices require high costs, but are efficient in terms of speed and can be suitable for high-speed charging of mobile devices.

### SUMMARY

The present disclosure attempts to provide a semiconductor device having improved reliability.

According to an aspect of the disclosure, a semiconductor device including: a substrate including (i) a first active region comprising a plurality of unit cells, and (ii) a peripheral area surrounding at least a portion of the first active region; a gate frame comprising (i) a first portion in a wiring region and extending along a first direction, (ii) a second portion extending from one side of the first portion along a second direction crossing the first direction and connected to a first end of at least a portion among the plurality of unit cells, and (iii) a third portion extending from the first side along the second direction and connected to a second end of at least a portion among the plurality of unit cells; a first gate runner on the first portion of the gate frame and the second portion of the gate frame; and a second gate runner on the third portion, in which a first distance between the first portion of the gate frame and a first contact portion where the first gate runner and the second portion of the gate frame are connected is shorter than a second distance between the first portion of the gate frame and a second contact portion where the second gate runner and the third portion of the gate frame are connected.

According to an embodiment, the plurality of unit cells in the first active region comprise a plurality of first unit cells overlapping with the first contact portion in the first direction and a plurality of second unit cells overlapping with the second contact portion in the first direction.

According to an aspect of the disclosure, a semiconductor device, including: a substrate including (i) a first active region comprising a plurality of unit cells, and (ii) a peripheral area surrounding at least a portion of the first active region; a gate frame comprising (i) a first portion in the peripheral area and extending along a first direction, (ii) a second portion extending from one side of the first portion along a second direction crossing the first direction and connected to first end of at least a portion among the plurality of unit cells, and (iii) a third portion extending from the first side along the second direction and connected to second end of at least a portion among the plurality of unit cells; a gate pad at a point where the first portion of the gate frame and the third portion of the gate frame are connected; a first gate runner on the first portion of the gate frame and the second portion of the gate frame; and a second gate runner on the third portion of the gate frame, and extending from a first side of the gate pad along the second direction, in which the first gate runner and the second portion of the gate frame are connected through a first contact portion, and the second gate runner and the third portion of the gate frame are connected through a second contact portion, and in which a first distance from the one side of the first portion of the gate frame to the first contact portion is shorter than a second distance from a center of the gate pad to the second contact portion.

According to an aspect of the disclosure, a semiconductor device, includes: a substrate including (i) a plurality of active regions spaced apart in a first direction and comprising a plurality of unit cells, and (ii) a peripheral area surrounding at least a portion of the plurality of active regions; a gate frame including (i) a first portion located in the peripheral area and extending along the first direction, (ii) a third portion extending from one side between a first end and a second end of the first portion along a second direction crossing the first direction, and (iii) a second portion and a fourth portion extending along the second direction and spaced apart from each other in the first direction with the third portion between the second portion and the fourth portion; a gate pad on a central portion between the first end and the second end of the first portion of the gate frame; a first gate runner on a portion of the first portion of the gate frame and the second portion of the gate frame; a second gate runner on the third portion of the gate frame; and a third gate runner located on another portion of the first portion of the gate frame, and the fourth portion of the gate frame, in which the first gate runner and the second portion of the gate frame are connected through a first contact portion, and the second gate runner and the third portion of the gate frame are connected through a second contact portion, and the third gate runner and the fourth portion are connected through a third contact portion, and in which a first distance from the gate pad to the first contact portion along a direction in which the first gate runner extends and a second distance from the gate pad to the third contact portion along a direction in which the third gate runner extends are the same as a third distance from the gate pad to the second contact portion along a direction in which the second gate runner extends.

**In** a semiconductor device according to embodiments, the gate contact region may be formed in only a partial region of the gate runner and the gate bus, and may be designed such that distances from the gate pad to the respective gate contact regions may be the same. According to one or more embodiments, the difference in timing at which gate signals for a plurality of unit cells are transmitted can be minimized, and accordingly, the reliability of the semiconductor device may be improved.

At least some of the above and other features of the invention are set out in the claims.

### BRIEF DESCRIPTION OF DRAWINGS

FIG. 1 is a top plan view showing a semiconductor device according to one or more embodiments.
FIG. 2 is a top plan view showing an active region and peripheral area of a semiconductor device according to one or more embodiments.
FIG. 3 is a cross-sectional view of a semiconductor device taken along line l1-l1' of FIG. 2.
FIG. 4 is a cross-sectional view of a semiconductor device taken along line l2-l2' of FIG. 2.
FIG. 5 is a cross-sectional view of a semiconductor device taken along line l3-l3' of FIG. 2.
FIG. 6 is a top plan view showing a semiconductor device according to one or more embodiments.
FIG. 7 is a top plan view showing a semiconductor device according to one or more embodiments.
FIG. 8 is a top plan view showing a semiconductor device according to one or more embodiments.
FIG. 9 to FIG. 19 are process cross-sectional views for explaining a manufacturing process of a semiconductor device according to one or more embodiments.

### DETAILED DESCRIPTION

The present disclosure will be described in detail hereinafter with reference to the accompanying drawings, in which embodiments of the present disclosure are shown. As those skilled in the art would realize, the described embodiments may be modified in various different ways, all without departing from the spirit or scope of the present disclosure.

The drawings and description are to be regarded as illustrative in nature and not restrictive. Like reference numerals designate like elements throughout the specification.

A size and thickness of each constituent element in the drawings are arbitrarily illustrated for better understanding and ease of description, the following embodiments are not limited thereto. In the drawings, the thickness of layers, films, panels, regions, etc., are exaggerated for clarity. In the drawings, the thickness of some layers and regions may be exaggerated for ease of description.

In addition, it will be understood that when an element such as a layer, film, region, or substrate is referred to as being "above" or "on" another element, it can be directly on the other element or intervening elements may also be present. In contrast, when an element is referred to as being "directly on" another element, there are no intervening elements present. Further, when an element is referred to as being "above" or "on" a reference element, it can be located above or below the reference element, and it is not necessarily referred to as being located "above" or "on" in a direction opposite to gravity. Where two components are described as "overlapping" in a particular direction, they may be arranged such that a line that is parallel to the particular direction can be positioned such that it intersects at least a portion of each of the two components.

In addition, unless explicitly described to the contrary, the word "comprise", and variations such as "comprises" or "comprising", will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

It will be understood that, although the terms first, second, third, fourth, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the disclosure.

The specification uses the terms of degree including "substantially" or "about." In one or more examples, when specifying that a parameter X may be substantially the same as parameter Y, the term "substantially" may be understood as X being within 10% of Y. In one or more examples, when specifying that a parameter is about X, the term "about" may be understood as being within 10% of X.

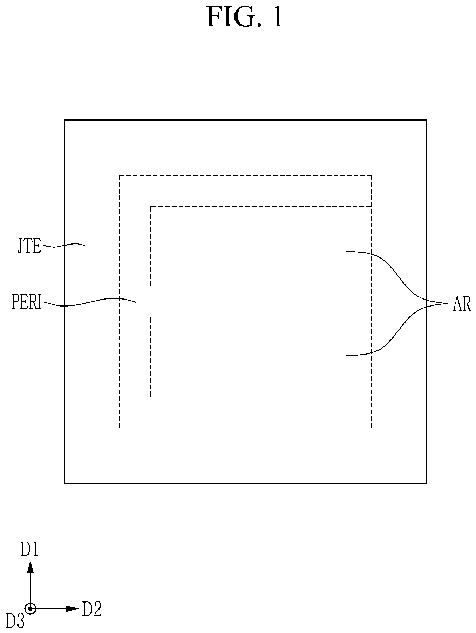

Hereinafter, a semiconductor device according to some embodiments will be described with reference to FIG. 1 to FIG. 5.

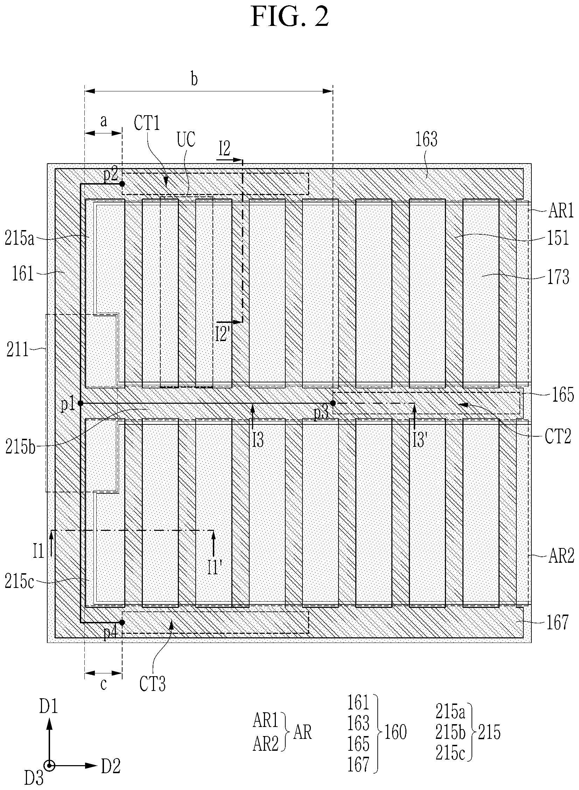

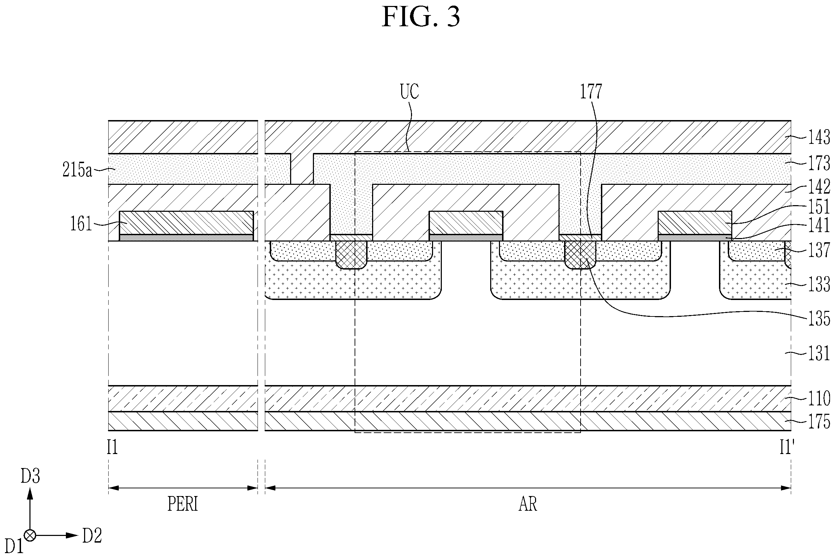

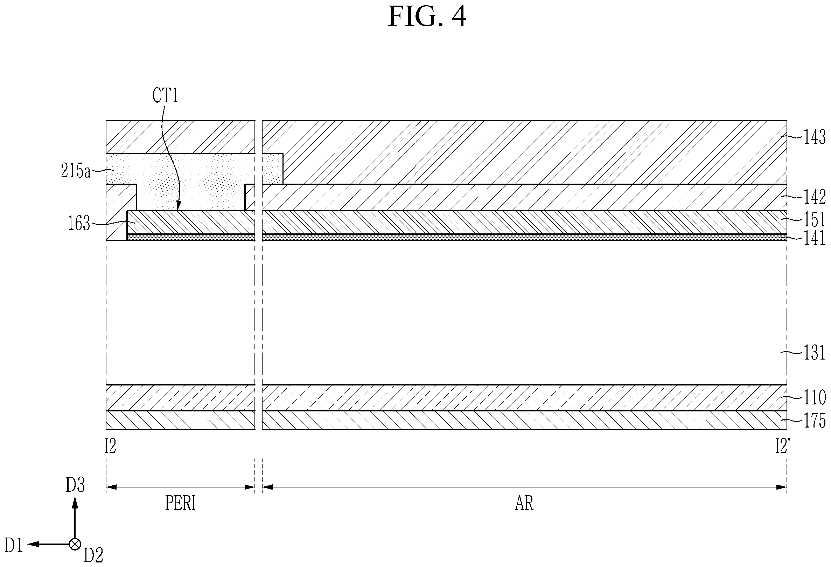

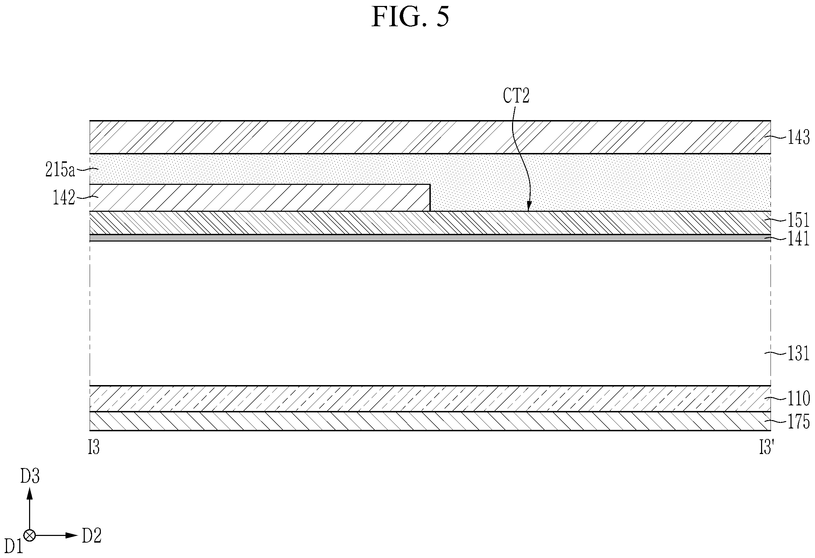

FIG. 1 is a top plan view showing a semiconductor device according to one or more embodiments. FIG. 2 is a drawing for specifically explaining an active region and a peripheral area of a semiconductor device according to one or more embodiments. FIG. 3 is a cross-sectional view of a semiconductor device taken along line l1-l1' of FIG. 2. FIG. 4 is a cross-sectional view of a semiconductor device taken along line l2-l2' of FIG. 2. FIG. 5 is a cross-sectional view of a semiconductor device taken along line l3-l3' of FIG. 2.

First, referring to FIG. 1, in one or more embodiments, a substrate 110 may include a peripheral area PERI surrounding a first active region AR, and a second active region AR A junction termination extension region JTE is located on an outer side of the peripheral area PERI. Although FIG. 1 illustrates that peripheral area PERI includes a space at one side (e.g., left side) and top and bottom sides of the active regions AR, the embodiment are not limited to this configuration. For example, the peripheral area PERI may surround the active regions AR such that the peripheral area PERI includes a space on both sides (e.g., left side and right side) of the active regions AR.

The junction termination extension region JTE may be located on an edge of the semiconductor device. The junction termination extension region JTE may include various structures to disperse the electric field concentrated in the edge region of a semiconductor device according to one or more embodiments, thereby preventing the semiconductor device from experiencing an insulation breakdown.

The active region AR may be a region where a semiconductor device, according to one or more embodiments, operates. For example, semiconductor devices such as transistors and electrodes for supplying signals or power may be located in the active region AR.

In FIG. 1, it is illustrated that two active regions AR are spaced apart from each other along a first direction D1, but the number and position of the active regions AR included on the substrate 110 is not limited thereto. For example, only one active region AR may be located on the substrate 110, or three or more the active regions AR may be arranged in various ways. The active region AR may be a region where charges move when a semiconductor device according to one or more embodiments is operating. For example, when a semiconductor device according to one or more embodiments operates, charges may move between a source electrode and a drain electrode described later, within the active region AR. A plurality of unit cells UC (see FIG. 3) may be arranged in the active region AR. The plurality of unit cells UC (see FIG. 3) may be coupled in parallel to each other.

The peripheral area PERI may surround the active region AR. The peripheral area PERI may surround at least a portion of the active region AR. As shown in FIG. 1, when the two active or more regions AR are included on the substrate 110, the peripheral area PERI may surround at least a portion of each of the active regions AR. In one or more embodiments, it is illustrated that the peripheral area PERI has a generally 'C' shape that surrounds three edges of each of the active regions AR, but is not limited thereto. For example, the peripheral area PERI may surround an entire circumference of the active region AR, or surround a portion of the entire circumference.

Various components for supplying electric power or electrical signals to the unit cells UC (see FIG. 3) may be located in the peripheral area PERI. For example, a gate frame 160 for interconnecting the plurality of unit cells UC (see FIG. 3), or gate runners 215 (see FIG. 2) for providing gate signals to the plurality of unit cells UC (see FIG. 3) may be located in the peripheral area PERI.

In FIG. 1, for better understanding and ease of description, it has been illustrated as if there exists a boundary between the active region AR and the peripheral area PERI, but there may not be a physical boundary that clearly distinguishes the active region AR and the peripheral area PERI. In other words, the peripheral area PERI and the active region AR may include a partially overlapping region around the boundary. For example, the gate runner 215 (see FIG. 2) described later may be partially located in the active region AR.

FIG. 2 to FIG. 5 are drawings for specifically explaining the active region and the peripheral area of a semiconductor device according to one or more embodiments. For example, FIG. 2 is a top plan view showing the active region and the peripheral area of a semiconductor device according to one or more embodiments, and FIG. 3 is a cross-sectional view of a semiconductor device taken **along line** l1-l1' of FIG. 2, and FIG. 4 is a cross-sectional view of a semiconductor device taken along line l2-l2' of FIG. 2, and FIG. 5 is a cross-sectional view of a semiconductor device taken along line l3-l3' of FIG. 2.

A semiconductor device, according to one or more embodiments, may include the substrate 110 including active regions AR1 and AR2 and the peripheral area PERI (see FIG. 1), the gate frame 160 located in the peripheral area PERI (see FIG. 1), and the gate runner 215 located on the gate frame 160.

The substrate 110 may be a semiconductor substrate including SiC. For example, the substrate 110 may be formed as a 4H SiC substrate. In one or more examples, the substrate 110 may be formed as a 3C SiC substrate, a 6H SiC substrate, or the like. The substrate 110 may be doped with a first conductivity type impurity. For example, the first conductivity type impurity may be an n-type impurity. In one or more examples, the substrate 110 may be doped to n-type. The substrate 110 may be doped to n-type at a high concentration. The resistivity of the substrate 110 may be about 0.005Ωcm or more and about 0.035Ωcm or less (e.g. between 0.005Ωcm and 0.035Ωcm). A thickness of the substrate 110 may be about 200 µm or more and about 700 µm or less (e.g. between 200 µm and 700 µm). The material, doping type, doping concentration, resistivity, thickness, or the like of the substrate 110 are not limited thereto, and may be changed in various ways.

The plurality of unit cells UC may be located in the active region AR of the substrate 110. As shown in FIG. 2, when two active regions AR are located on the substrate 110, the plurality of unit cells UC may be located within each of the active regions AR1 and AR2. The number of unit cells UC in each active region may be the same or different from each other. In one or more examples, each unit cell UC may have a same size. In one or more examples, the unit cells in different active regions may have a different size and/or shape. For example, a unit cell in active region AR1 and a unit cell in active region AR2 may have a different size and/or shape from each other. In one or more examples, two unit cells in the same active region may have a different size and/or shape from each other.

The unit cell UC may be a smallest unit element that performs a specific function according to signals received from the outside. In one or more embodiments, the unit cell UC may be a switch (e.g. a transistor). For instance, the unit cell UC may be a metal-oxide-semiconductor field effect transistor (MOSFET) or an insulated-gate bipolar transistor (IGBT). In FIG. 2 to FIG. 5, it is illustrated that the unit cell UC has a MOSFET structure in a planar type, but the structure of the unit cell UC is not limited thereto. For example, the unit cell UC may have a trench type MOSFET, or a super junction type MOSFET structure. For example, the unit cell UC may have an IGBT structure.

In one or more embodiments, each of the plurality of unit cells UC may extend in the first direction D1. The plurality of unit cells UC may be arranged in a second direction D2 within the active region AR1 and AR2. In one or more embodiments, the second direction D2 may be a direction crossing the first direction D1. For example, the second direction D2 may be a direction perpendicular to the first direction D1. The first direction D1 and second direction D2 may be parallel to a plane of the substrate 110 (e.g. parallel to an upper surface of the substrate 110 upon which the unit cells UC are arranged). The plurality of unit cells UC may be arranged along the second direction D2 to form one row. Referring to FIG. 2 and FIG. 3, it is illustrated that eight unit cells are arranged in the second direction D2, but the number of the unit cells arranged within a first active region AR1 and a second active region AR2, respectively, is not limited.

Each of the unit cells UC may be connected to the gate frame 160 described later. For example, gate electrodes 151 included in each of the unit cells UC may extend in the first direction D1. The gate electrodes 151 may be connected to the gate frame 160. In one or more embodiments, within the first active region AR1, a first end of each of the unit cells UC may be connected to a second portion 163 of the gate frame 160, and a second end of each of the unit cells UC may be connected to a third portion 165 of the gate frame 160. In one or more embodiments, within the second active region AR2, the first end of each of the unit cells UC may be connected to the third portion 165 of the gate frame 160, and the second end of each of the unit cells UC may be connected to a fourth portion 167 of the gate frame 160.

One or more of the unit cells UC may be located on a first surface of the substrate 110, and others thereof may be located on a second surface facing the first surface of the substrate 110. In the present disclosure, the first surface of the substrate 110 may be referred to as an upper surface of the substrate 110, and the second surface of the substrate 110 may be referred to as a lower surface of the substrate 110. The terms "upper" and "lower" may refer to a relative position along a third direction D3 (e.g. a thickness direction of the substrate 110). It will be appreciated that these terms, and similar terms (such as "above", "below", etc.) are defined relative to the structure of the semiconductor device, and need not imply any particular orientation of the semiconductor device, in use.

Referring to FIG. 2 and FIG. 3, a semiconductor device, according to one or more embodiments, may include a first conductivity type semiconductor layer 131 located on the first surface of the substrate 110, a second conductivity type doping well region 133 located within the first conductivity type semiconductor layer 131, the gate electrode 151 located on the first conductivity type semiconductor layer 131 and the second conductivity type doping well region 133, a gate insulating layer 141 located between the first conductivity type semiconductor layer 131 and the gate electrode 151, a first interlayer insulating layer 142 covering an upper surface and a side surface of the gate electrode 151, a source electrode 173 located on the second conductivity type doping well region 133, and a drain electrode 175 located on the second surface of the substrate 110. In one or more embodiments, the structure shown in the active region AR of FIG. 3 may be a structure in which the unit cells UC are arranged along the second direction D2.

The first conductivity type semiconductor layer 131 may be located on the first surface of the substrate 110, i.e., on an upper surface. A lower surface of the first conductivity type semiconductor layer 131 may be in contact with the upper surface of the substrate 110. However, it is not limited thereto, and another predetermined layer may be further located between the substrate 110 and the first conductivity type semiconductor layer 131. The first conductivity type semiconductor layer 131 may be an epitaxy layer formed from the substrate 110 by using an epitaxial growth method. The first conductivity type semiconductor layer 131 may include SiC. For example, the first conductivity type semiconductor layer 131 may include 4H SiC. The first conductivity type semiconductor layer 131 may be doped to n-type. The first conductivity type semiconductor layer 131 may be doped to n-type at a low concentration. The doping concentration of the first conductivity type semiconductor layer 131 may be lower than the doping concentration of the substrate 110.

The second conductivity type doping well region 133 may be located in the active region AR. Referring to FIG. 3, it is illustrated that the second conductivity type doping well region 133 is not located in the peripheral area PERI, but it is not limited thereto, and the second conductivity type doping well region 133 may also be located in the peripheral area PERI.

The second conductivity type doping well region 133 may be located within the first conductivity type semiconductor layer 131. The second conductivity type doping well region 133 may be located on an upper portion of the first conductivity type semiconductor layer 131. The second conductivity type doping well region 133 may be in contact with a lower surface of a second conductivity type doping layer 135 to be described later. The second conductivity type doping well region 133 may surround a lower surface and a side surface of a first conductivity type doping layer 137 to be described later. In one or more embodiments, at least a partial region of an upper surface of the second conductivity type doping well region 133 may overlap with at least a portion of the gate electrode 151 to be described later and at least a portion of the gate insulating layer 141 to be described later in the third direction D3. In one or more embodiments, the third direction D3 may mean a thickness direction of the substrate 110. In one or more embodiments, the third direction D3 may be a direction crossing the first direction D1 and the second direction D2. For example, the third direction D3 may be a direction perpendicular to the first direction D1 and the second direction D2. The first direction D1 may be perpendicular to the second direction D2.

In one or more embodiments, the second conductivity type doping well region 133 may be formed in at least a partial region of the first conductivity type semiconductor layer 131 through the ion implantation method. Therefore, the second conductivity type doping well region 133 may be located from an upper surface of the first conductivity type semiconductor layer 131 toward a lower surface to a predetermined depth.

According to one or more embodiments, the second conductivity type doping well region 133 may extend in the first direction D1. For example, the second conductivity type doping well region 133 may extend to a boundary region between the active region AR and the peripheral area PERI.

The second conductivity type doping well region 133 may include SiC. For example, the second conductivity type doping well region 133 may include 4H SiC. The second conductivity type doping well region 133 may be doped to p-type. The second conductivity type doping well region 133 may be doped to p-type at a low concentration. The doping concentration of the second conductivity type doping well region 133 may be about 1*10¹⁷cm⁻³ or more and about 1*10¹⁹cm⁻³ or less (e.g. between 1*10¹⁷cm⁻³ and 1*10¹⁹cm⁻³). The material, doping type, doping concentration, etc. of the second conductivity type doping well region 133 is not limited thereto, and may be changed in various ways.

A semiconductor device according to one or more embodiments may further include the second conductivity type doping layer 135 and the first conductivity type doping layer 137 located above the upper portion of the first conductivity type semiconductor layer 131.

The second conductivity type doping layer 135 may be located within the second conductivity type doping well region 133. The second conductivity type doping layer 135 may be located in the upper portion of the first conductivity type semiconductor layer 131, and may have an upper surface in direct contact with a lower surface of a silicide layer 177 connected to the source electrode 173 to be described later.

According to one or more embodiments, the second conductivity type doping layer 135 may extend in the first direction D1. For example, the second conductivity type doping layer 135 may extend to the boundary region between the active region AR and the peripheral area PERI.

In one or more embodiments, a thickness of the second conductivity type doping layer 135 along the third direction D3 may be smaller than a thickness of the second conductivity type doping well region 133 along the third direction D3. The second conductivity type doping layer 135 may have a narrower width than the second conductivity type doping well region 133. For example, the second conductivity type doping layer 135 may be located within the second conductivity type doping well region 133. The second conductivity type doping layer 135 may be formed in at least a partial region of the second conductivity type doping well region 133 through the ion implantation method.

The second conductivity type doping layer 135 may include SiC. For example, the second conductivity type doping layer 135 may include 4H SiC. The second conductivity type doping layer 135 may be doped to p-type. The second conductivity type doping layer 135 may form ohmic contact with the source electrode 173. To this end, the second conductivity type doping layer 135 may be doped to p-type at a high concentration. In one or more embodiments, the doping concentration of the second conductivity type doping layer 135 may be higher than the doping concentration of the second conductivity type doping well region 133. The doping concentration of the second conductivity type doping layer 135 may be about 1*10¹⁸cm⁻³ or more and about 5*10²⁰cm⁻³ or less (e.g. between 1*10¹⁸cm⁻³ and 5*10²⁰cm⁻³). The material, doping type, doping concentration, etc. of the second conductivity type doping layer 135 is not limited thereto, and may be changed in various ways to any suitable material or concentration level known to one of ordinary skill in the art.

The first conductivity type doping layer 137 may be located within the second conductivity type doping well region 133, in the active region AR. The first conductivity type doping layer 137 may be located in the upper portion of the first conductivity type semiconductor layer 131, and may surround both side surfaces of the second conductivity type doping layer 135. An upper surface of the first conductivity type doping layer 137 may overlap with at least a portion of the gate electrode 151 described later and at least a portion of the gate insulating layer 141 in the third direction D3. In addition, the upper surface of the first conductivity type doping layer 137 may overlap with at least a portion of the described later source electrode 173 in the third direction D3, but is not limited thereto. The upper surface of the first conductivity type doping layer 137 may be in direct contact with a partial region of the gate insulating layer 141 to be described later.

The first conductivity type doping layer 137 may be located within the second conductivity type doping well region 133. In one or more examples, a thickness of the first conductivity type doping layer 137 along the third direction D3 may be smaller than the thickness of the second conductivity type doping well region 133 along the third direction D3. In one or more examples, a thickness of the first conductivity type doping layer 137 along the third direction D3 may be smaller than the thickness of the second conductivity type doping layer 135 along the third direction D3.

According to one or more embodiments, the first conductivity type doping layer 137 may extend in the first direction D1. For example, the first conductivity type doping layer 137 may extend to the boundary region between the active region AR and the peripheral area PERI.

The first conductivity type doping layer 137 may be a doping region formed within the first conductivity type semiconductor layer 131 by using the ion implantation process. The first conductivity type doping layer 137 may include SiC. For example, the first conductivity type doping layer 137 may include 4H SiC. The first conductivity type doping layer 137 may be doped to n-type. The first conductivity type doping layer 137 may be doped to n-type at a high concentration. The doping concentration of the first conductivity type doping layer 137 may be about 1*10¹⁸cm⁻³ or more and about 5*10²⁰cm⁻³ or less (e.g. between 1*10¹⁸cm⁻³ and 5*10²⁰cm⁻³ or less). The material, doping type, doping concentration, etc. of the first conductivity type doping layer 137 is not limited thereto, and may be changed in various ways to any suitable material or concentration level known to one of ordinary skill in the art.

In the active region AR, the gate electrode 151 may be located on the first conductivity type semiconductor layer 131. The gate electrode 151 may be spaced apart from the first conductivity type semiconductor layer 131. For example, the gate electrode 151 may be spaced apart from the first conductivity type semiconductor layer 131 in vertical direction (e.g., the third direction D3) by the gate insulating layer 141.

A semiconductor device according to one or more embodiments may have a planar gate structure. That is, in a semiconductor device according to one or more embodiments, the gate electrode 151 may have a flat plate shape having flat upper and lower surfaces, and a lower surface of the gate electrode 151 may be located at a higher level than an uppermost surface of the first conductivity type semiconductor layer 131. However, it is not limited thereto, and a semiconductor device according to one or more embodiments may have a gate structure of a trench form. For example, in a semiconductor device according to one or more embodiments, a trench of a predetermined depth may be formed in the first conductivity type semiconductor layer 131, and the gate electrode 151 may be located within the trench to be spaced apart from the first conductivity type semiconductor layer 131 in the third direction D3. In addition, the gate electrode 151 may be spaced apart from the first conductivity type semiconductor layer 131 in a horizontal direction (the first direction D1 and/or the second direction D2).

In one or more embodiments, the gate electrode 151 may overlap with the second conductivity type doping well region 133 and the first conductivity type doping layer 137 in the third direction D3. Referring to FIG. 3, the second conductivity type doping well region 133 and the first conductivity type doping layer 137 may partially overlap with an edge region of the gate electrode 151. The gate electrode 151 may include a conductive material. For example, the gate electrode 151 may include polysilicon doped with impurities. As another example, the gate electrode 151 may include a metal, a metal alloy, a conductive metal nitride, a metal silicide, a doped semiconductor material, a conductive metal oxide, a conductive metal nitride oxide, or a combination thereof. The gate electrode 151 may be formed as a single layer or multi-layer.

The gate electrode 151 included in each of the unit cells UC may extend in the first direction D1. Referring to FIG. 2 and FIG. 3, the gate electrode 151 may extend to the boundary region between the active region AR and the peripheral area PERI. The gate electrode 151 may be connected to the gate frame 160 described later. In one or more embodiments, the gate electrode 151 may be integrally formed with the gate frame 160. Referring to FIG. 2, first ends of the gate electrodes included in the first active region AR1 may be connected to the second portion 163, and second ends may be connected to the third portion 165. First ends of the gate electrodes included in the second active region AR2 may be connected to the third portion 165, and second ends (e.g., ends opposite to the first ends) may be connected to the fourth portion 167.

The gate insulating layer 141 may be located between the first conductivity type semiconductor layer 131 and the gate electrode 151. In one or more embodiments, the gate insulating layer 141 may also be located between the first conductivity type semiconductor layer 131 and the gate frame 160 described later. That is, the gate insulating layer 141 may be located below the gate electrode 151 and/or the gate frame 160, and may cover a lower surface of the gate electrode 151 and/or the gate frame 160. The gate electrode 151 and the gate frame 160 may be insulated from the first conductivity type semiconductor layer 131 by the gate insulating layer 141. In one or more embodiments, a thickness of the gate insulating layer 141 may be substantially constant.

A lower surface of the gate insulating layer 141 may be in direct contact with the second conductivity type doping well region 133 and the first conductivity type doping layer 137, but is not limited thereto. The gate insulating layer 141 may include an insulating material. For example, the gate insulating layer 141 may include silicon oxide (SiO₂). However, it is not limited thereto, and a material of the gate insulating layer 141 may be changed in various ways. As another example, the gate insulating layer 141 may include silicon nitride (SiNₓ), silicon oxynitride (SiON), silicon carbide (SiC), silicon carbon nitride (SiCN) or a combination thereof. The gate insulating layer 141 may be formed as a single layer or multi-layer.

The first interlayer insulating layer 142 may be located on the first conductivity type semiconductor layer 131. For example, in the active region AR, the first interlayer insulating layer 142 may be located on the gate electrode 151. For example, the first interlayer insulating layer 142 may cover the upper surface and the side surface(s) of the gate electrode 151. The first interlayer insulating layer 142 may cover a side surface(s) of the gate insulating layer 141. The first interlayer insulating layer 142 may also be located on a first conductivity type doping layer 137. The first interlayer insulating layer 142 may have a lower surface in contact with at least a portion of the upper surface of the first conductivity type doping layer 137. The gate electrode 151 may be insulated from the source electrode 173 by the first interlayer insulating layer 142.

The first interlayer insulating layer 142 may include an insulating material. In one or more embodiments, the first interlayer insulating layer 142 may include the same insulating material as the gate insulating layer 141. For example, the first interlayer insulating layer 142 may include silicon oxide (SiO₂). However, it is not limited thereto, and the first interlayer insulating layer 142 may include various types of insulating materials for insulating the gate electrode 151 from the source electrode 173. For example, the first interlayer insulating layer 142 may include silicon nitride (SiN_{X}), silicon oxynitride (SiON) or a combination thereof. The first interlayer insulating layer 142 may be formed as a single layer or multi-layer. When the first interlayer insulating layer 142 is formed of the same material as the gate insulating layer 141, a boundary between the first interlayer insulating layer 142 and the gate insulating layer 141 may not be clearly distinguished in a portion where the first interlayer insulating layer 142 and the gate insulating layer 141 are in contact with each other.

The source electrode 173 may be located on the second conductivity type doping well region 133. The source electrode 173 may not be located in the peripheral area PERI. The second conductivity type doping layer 135 and the first conductivity type doping layer 137 may be located between the source electrode 173 and the second conductivity type doping well region 133. The source electrode 173 may be electrically connected to the second conductivity type doping well region 133 by the second conductivity type doping layer 135. A connection portion where the source electrode 173 and the second conductivity type doping layer 135 are connected may be located on both sides of the gate electrode 151. The first interlayer insulating layer 142 may be located between the source electrode 173 and the gate electrode 151. Through the source electrode 173, a current or voltage may be provided to a semiconductor device according to one or more embodiments. The source electrode 173 may be spaced apart from the gate electrode 151 by the first interlayer insulating layer 142. The source electrode 173 may be in contact with a side surface of the first interlayer insulating layer 142.

The source electrode 173 may include a conductive material. For example, the source electrode 173 may include a metal, a metal alloy, a conductive metal nitride, a metal silicide, a doped semiconductor material, a conductive metal oxide, a conductive metal nitride oxide, or the like. For example, the source electrode 173 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 173 may be formed as a single layer or multi-layer.

A semiconductor device according to one or more embodiments may further include the silicide layer 177 located between the source electrode 173 and the second conductivity type doping layer 135.

The silicide layer 177 may be conformally located along the interface between the source electrode 173 and the second conductivity type doping layer 135 and between the source electrode 173 and the first conductivity type doping layer 137. The lower surface of the silicide layer 177 may be in direct contact with the second conductivity type doping layer 135. An upper surface of the silicide layer 177 may be in direct contact with the source electrode 173. In one or more examples, the silicide layer may provide an ohmic contact or interconnect for integrated circuits due to low electrical resistivity and good compatibility with silicon substrates.

The silicide layer 177 may include a metal silicide material. For example, the silicide layer 177 may include tungsten silicide (WSi), titanium silicide (TiSi), cobalt silicide (CoSi), nickel silicide (NiSi), or a combination thereof.

A semiconductor device according to one or more embodiments may further include a second interlayer insulating layer 143 covering the source electrode 173. The second interlayer insulating layer 143 may protect detailed configurations of a semiconductor device according to one or more embodiments. For example, the second interlayer insulating layer 143 may be a layer for preventing doped regions, conductive electrodes, or the like, of a semiconductor device according to one or more embodiments from being exposed to oxygen or moisture. The second interlayer insulating layer 143 may electrically separate the source electrode 173 from the gate runner 215 described later. The second interlayer insulating layer 143 may be formed in a sufficient thickness to completely cover doped regions, conductive electrodes, or the like of the semiconductor device.

The second interlayer insulating layer 143 may be located entirely over the active region AR and the peripheral area PERI. The second interlayer insulating layer 143 may entirely cover the source electrode 173. The second interlayer insulating layer 143 may cover the gate runner 215 described later. The second interlayer insulating layer 143 may also be located between the source electrode 173 and the gate runner 215.

The second interlayer insulating layer 143 may include an insulating material. The second interlayer insulating layer 143 may include a material having chemical, mechanical, and high-temperature stability. For example, the second interlayer insulating layer 143 may be composed of a polymer layer such as polyimide (PI), but is not limited thereto. The second interlayer insulating layer 143 may further include various insulating materials such as silicon oxide (SiO₂), silicon nitride (SiN_{X}), silicon oxynitride (SiON), silicon carbide (SiC), silicon carbon nitride (SiCN) or a combination thereof, together with the polymer layer.

The drain electrode 175 may be located on the second surface of the substrate 110, that is, the lower surface. An upper surface of the drain electrode 175 may be in contact with the lower surface of the substrate 110. The drain electrode 175 may be in ohmic contact with the substrate 110. A region in contact with the drain electrode 175 within the substrate 110 may be doped at a relatively high concentration compared to other regions. However, it is not limited thereto, and another predetermined layer may be further located between the drain electrode 175 and the substrate 110. For example, the silicide layer may be located between the drain electrode 175 and the substrate 110. The silicide layer may include a metal silicide material. By the metal silicide layer, the drain electrode 175 and the substrate 110 may be electrically connected smoothly.

The drain electrode 175 may include a conductive material. For example, the drain electrode 175 may include a metal, a metal alloy, a conductive metal nitride, a metal silicide, a doped semiconductor material, a conductive metal oxide, a conductive metal nitride oxide, or any other suitable material known to one of ordinary skill in the art. The drain electrode 175 may be formed of the same material as the source electrode 173, and may be formed of a different material therefrom. The drain electrode 175 may be formed as a single layer or multi-layer.

The gate frame 160, and the gate runner 215 may be located in the peripheral area **PERI** of the substrate 110. Referring to FIG. 2 to FIG. 5, in the peripheral area **PERI,** the gate insulating layer 141, the gate frame 160, and the gate runner 215 may be sequentially located along the third direction D3, on the first conductivity type semiconductor layer 131 described above.

The gate frame 160 may be located in the peripheral area **PERI.** The gate frame 160 may surround the active region AR. The gate frame 160 may transfer electrical signals provided from the outside (e.g. from an external device) to the gate electrodes 151 of the active region AR. The gate frame 160 may transfer electrical signals provided from the outside to the entire active region AR, through a first portion 161, the second portion 163, the third portion 165, and the fourth portion 167 surrounding the active region AR. Although FIG. 2 illustrates that the gate frame 160 surrounds three edges of the active regions AR1 and AR2, the embodiments are not limited to this configuration. For example, for a rectangular shaped active region, the gate frame 160 may be configured to surround all 4 edges of the rectangular active region.

The gate frame 160 may be located on the first conductivity type semiconductor layer 131. The gate frame 160 may be located in the same layer as the gate electrodes 151 described above. In one or more embodiments, the gate frame 160 may be integrally formed with the gate electrodes 151. In one or more embodiments, the gate frame 160 may be formed in the same process step as the gate electrodes 151. The gate insulating layer 141 may be located between the gate frame 160 and the first conductivity type semiconductor layer 131. In one or more embodiments, a width of the gate frame 160 along a horizontal direction (e.g., the first direction D1, or the second direction D2) may be wider than a width of the gate electrode 151 along the second direction D2. The gate frame 160 may be covered by the first interlayer insulating layer 142.

In one or more embodiments, the gate frame 160 may include the same material as the gate electrode 151. The gate frame 160 may include a conductive material. For example, the gate frame 160 may include polysilicon doped with impurities, where small amounts of foreign atoms (e.g., impurities) may be added to the polysilicon to alter its electrical properties to create either a p-type or n-type semiconductor. As another example, the gate frame 160 may include a metal, a metal alloy, a conductive metal nitride, a metal silicide, a doped semiconductor material, a conductive metal oxide, a conductive metal nitride oxide, or a combination thereof. The gate frame 160 may be formed as a single layer or multi-layer.

Referring to FIG. 2, the gate frame 160 may include the first portion 161, and the second portion 163, the third portion 165, and the fourth portion 167 connected to the first portion 161. The first portion 161 may extend in the first direction D1. The first portion 161 may extend in the same direction as the direction in which the unit cells UC or the gate electrode 151 extend. The first portion 161 may be spaced apart from an adjacent unit cell (e.g. a most adjacent, or closest, unit cell) among the unit cells UC in the second direction D2. The first portion 161 may be located along one edge of the peripheral area PERI described with reference to FIG. 1. In one or more embodiments, the first portion 161 may not be directly connected to the unit cells UC or the gate electrodes 151.

The second portion 163, the third portion 165, and the fourth portion 167 may extend from one side of the first portion 161. The second portion 163, the third portion 165, and the fourth portion 167 may extend from the one side of the first portion 161 along the second direction D2. The one side of the first portion 161 may be a side that faces the second direction D2 (e.g. that extends in the first direction D1). The one side of the first portion 161 may be a side that faces the active region(s) AR. The second portion 163, the third portion 165, and the fourth portion 167 may be spaced apart along the first direction D1.

The second portion 163 may extend along the second direction D2, from a side surface of a first end of the first portion 161. The second portion 163 may be located along an edge different from the edge where the first portion 161 is located, among edges of the peripheral area PERI described with reference to FIG. 1. For example, the second portion 163 may be located along an edge neighboring to the edge where the first portion 161 is located, among the edges of the peripheral area PERI.

The fourth portion 167 may extend along the second direction D2, from a side surface of a second end of the first portion 161. The second end of the first portion 161 may be opposite to the first end of the first portion 161. The fourth portion 167 may be located along an edge different from the edge where the first portion 161 and the second portion 163 are located, among the edges of the peripheral area PERI described with reference to FIG. 1. For example, the fourth portion 167 may be located along an edge located on a side opposite to edge where the second portion 163 is located, among the edges of the peripheral area PERI. The first portion 161, the second portion 163, and the fourth portion 167 may be connected to each other, and may have a shape generally similar to the shape of the letter 'C' (e.g. a C shape, or a U shape).

The third portion 165 may extend from a side surface of a central portion between the first end and the second end of the first portion 161. The third portion 165 may be located between the second portion 163 and the fourth portion 167. The third portion 165 may be located between the first active region AR1 and the second active region AR2. In one or more examples, each of the second portion 163, third portion 165, and the fourth portion 163 may have the same length in the direction D1 or D2. In one or more examples, at least one of the second portion 163, third portion 165, and the fourth portion 163 may have a different length in the direction D1 or D2.

In one or more embodiments, the second portion 163 and the third portion 165 may be connected to the unit cells UC located in the first active region AR1. For example, the second portion 163 and the third portion 165 may be connected to the gate electrode 151 of each of the unit cells UC located in the first active region AR1. Referring to FIG. 2, the first end of each of the unit cells UC located in the first active region AR1 may be connected to the second portion 163, and second end may be connected to the third portion 165.

In one or more embodiments, the third portion 165 and the fourth portion 167 may be connected to the unit cells UC located in the second active region AR2. For example, the third portion 165 and the fourth portion 167 may be connected to the gate electrode 151 of each of the unit cells UC located in the second active region AR2. Referring to FIG. 2, the first end of each of the unit cells UC located in the second active region AR2 may be connected to the third portion 165, and second end may be connected to the fourth portion 167.

A semiconductor device according to one or more embodiments may further include a gate pad 211 located on a partial region of the gate frame 160. The gate pad 211 may be a portion to which the electrical signal from the outside is directly applied. For example, the gate pad 211 may be a portion in contact with a metal wire, or the like, to which electrical signals for turning on and off a semiconductor device according to one or more embodiments are provided.

The gate pad 211 may overlap with a partial region of the gate frame 160 in the third direction D3. Referring to FIG. 2, the gate pad 211 may cover a partial region of the first portion 161. In one or more examples, the first interlayer insulating layer 142 may be located below the gate pad 211. For example, the first interlayer insulating layer 142 may be located between the gate pad 211 and the gate frame 160.

The gate pad 211 may be located between the first end and the second end of the first portion 161. Referring to FIG. 2, it is illustrated that the gate pad 211 is located on the central portion between the first end and the second end of the first portion 161, but the position of the gate pad 211 is not limited to this position, and may be placed closer to the first end of the first portion 161 or the second end of the first portion 161. In FIG. 2, it is illustrated that the gate pad 211 has a rectangular shape, but the shape of the gate pad 211 is not limited thereto, and may have various shapes such as a circular shape, an elliptical shape, a polygonal shape other than the rectangular shape, or any other suitable shape known to one of ordinary skill in the art.

The gate pad 211 may have a sufficiently wide area to facilitate contact with the metal wire, or the like. For example, a width of the gate pad 211 along the second direction D2 may be wider than a width of a first gate runner 215a along the second direction D2 located on the first portion 161. For example, the width of the gate pad 211 along the second direction D2 may be wider than a width of a third gate runner 215c along the second direction D2 located on the first portion 161. In one or more embodiments, the gate pad 211 may protrude further in the second direction D2 than the first gate runner 215a located on the first portion 161, based on a left side (e.g. outer) edge of the peripheral area PERI (see FIG. 1).

In one or more embodiments, a length along the first direction D1 of the gate pad 211 may be smaller than a length along the first direction D1 of the first gate runner 215a. A length along the second direction D2 of the gate pad 211 may be smaller than a length along the second direction D2 of a second gate runner 215b. In one or more embodiments, the gate pad 211 may be located in the same layer as the gate runner 215 described later. In one or more embodiments, the gate pad 211 may include the same material as the gate runner 215 described later. In one or more embodiments, the gate pad 211 may be integrally formed with the gate runner 215 described later.

The gate pad 211 may be located not only in the peripheral area PERI but also in the active region AR. Referring to FIG. 2, the gate pad 211 may cover a partial region of the active region AR. In one or more embodiments, the first interlayer insulating layer 142 may also be located below the gate pad 211 located in the active region AR. By the first interlayer insulating layer 142, the gate pad 211 may not be directly connected to the gate electrode 151, and/or semiconductor layers 131, 133, 135, and 137 located in the active region AR.

The gate pad 211 may include a conductive material. For example, the gate pad 211 may include a metal, a metal alloy, a conductive metal nitride, a metal silicide, a doped semiconductor material, a conductive metal oxide, a conductive metal oxynitride, or any other suitable material known to one of ordinary skill in the art. For example, the gate pad 211 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAlC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate pad 211 may be formed as a single layer or multi-layer.

The gate runner 215 may be located on the gate frame 160. In one or more embodiments, the first interlayer insulating layer 142 may be located between the gate runner 215 and the gate frame 160. The gate runner 215 may be connected to the gate pad 211 and the gate frame 160. The gate runner 215 may transfer the electrical signal applied to the gate pad 211 to the gate frame 160. For example, the gate runner 215 may be a metal that delivers gate current to a physical gate. In one or more embodiments, the gate runner 215 may be entirely covered by the second interlayer insulating layer 143.

The gate runner 215 may extend in the same direction as the direction in which the gate frame 160 extends. The gate runner 215 may include a region overlapping with the gate frame 160 in the third direction D3. Referring to FIG. 2, a width of the gate runner 215 according to the horizontal direction (e.g., the first direction D1 or the second direction D2, which is a direction perpendicular to the direction in which the gate runner 215 extends) may be wider than the width of the gate frame 160 according to the horizontal direction (e.g., the first direction D1 or the second direction D2, which is a direction perpendicular to the direction in which the gate frame 160 extends). However, it is not limited thereto, and a width of the gate runner 215 along a horizontal direction may be substantially the same as or narrower than, a width of the gate frame 160 along a horizontal direction. In one or more embodiments, the gate runner 215 may be connected to each of portions 163, 165, and 167 of the gate frame 160, through contact portions CT1, CT2, and CT3 described later.

In one or more embodiments, the gate runner 215 may include the first gate runner 215a, the second gate runner 215b, and the third gate runner 215c. The first gate runner 215a may be located on a portion of the first portion 161 of the gate frame 160, and the second portion 163. Referring to FIG. 2, the first gate runner 215a may extend from a side surface of the gate pad 211 facing the first direction D1.

The first gate runner 215a may extend along the direction in which the first portion 161 and the second portion 163 extend. The region located on the first portion 161 among an entire region of the first gate runner 215a may extend along the first direction D1. The region located on the second portion 163 among the entire region of the first gate runner 215a may extend along the second direction D2. Referring to FIG. 2, the first gate runner 215a may have a shape of roughly similar to inversion of the letter 'L'.

In one or more embodiments, a first contact portion CT1 where the first gate runner 215a and the second portion 163 of the gate frame 160 are connected to each other may be located in the region where the first gate runner 215a and the second portion 163 overlap in the third direction D3. For example, referring to FIG. 4, the first gate runner 215a may be connected to the second portion 163 through an opening formed in the first interlayer insulating layer 142. The first contact portion CT1 may form part of the first gate runner 215a. Referring to FIG. 4, the first gate runner 215a may fill the opening of the first interlayer insulating layer 142 formed in the region overlapping with the second portion 163. The first gate runner 215a may directly contact the second portion 163 of the gate frame 160. In one or more examples, the first gate runner 215a may be connected to the second portion 163 through a separate component (e.g. connector) located between the first gate runner 215a and the second portion 163.

The second gate runner 215b may be located on the third portion 165 of the gate frame 160. Referring to FIG. 2, the second gate runner 215b may extend from a side surface of the gate pad 211 facing the second direction D2.

The second gate runner 215b may extend along the direction in which the third portion 165 extends. For example, the second gate runner 215b may extend along the second direction D2. Referring to FIG. 2, the second gate runner 215b may have a straight shape extending in the second direction D2.

In one or more embodiments, a second contact portion CT2 where the second gate runner 215b and the third portion 165 of the gate frame 160 are connected to each other may be located in the region where the second gate runner 215b and the third portion 165 overlap in the third direction D3. For example, referring to FIG. 4, the second gate runner 215b may be connected to the third portion 165 through an opening formed in the first interlayer insulating layer 142. The second contact portion CT2 may form part of the second gate runner 215b. Referring to FIG. 4, the second gate runner 215b may fill the opening of the first interlayer insulating layer 142 formed in the region overlapping with the third portion 165. The second gate runner 215b may directly contact the third portion 165 of the gate frame 160. In one or more examples, the second gate runner 215b may be connected to the third portion 165 through a separate component (e.g. connector) located between the second gate runner 215b and the third portion 165.

The third gate runner 215c may be located on another portion of the first portion 161 of the gate frame 160, and the fourth portion 167. The another portion of the first portion 161 may mean a region that does not overlap with the first gate runner 215a in the third direction D3, among an entire region of the first portion 161. Referring to FIG. 2, the third gate runner 215c may extend from a side surface facing a direction opposite to the first direction D1 of the gate pad 211.

The third gate runner 215c may extend along the direction in which the first portion 161 and the fourth portion 167 extend. The region located on the first portion 161 among an entire region of the third gate runner 215c may extend along the first direction D1. The region located on the fourth portion 167 among the entire region of the third gate runner 215c may extend along the second direction D2. Referring to FIG. 2, the first gate runner 215a may have generally the shape of the letter 'L'.

In one or more embodiments, a third contact portion CT3 where the third gate runner 215c and the fourth portion 167 of the gate frame 160 are connected to each other may be located in the region where the third gate runner 215c and the fourth portion 167 overlap in the third direction D3. The method by which the third gate runner 215c and the fourth portion 167 are connected may be the same as the method by which the first gate runner 215a and the second portion 163 are connected, and detailed description thereon will be omitted.

In one or more embodiments, the first gate runner 215a and the third gate runner 215c may be spaced apart in the first direction D1 with the second gate runner 215b located between the first gate runner 215a and the third gate runner 215c. The first gate runner 215a and the third gate runner 215c may be spaced apart from the second gate runner 215b by substantially the same distance in the first direction D1. In one or more embodiments, the first gate runner 215a and the third gate runner 215c may have symmetrical shapes based on the second gate runner 215b (e.g. based on an axis of symmetry running along the second gate runner 215b).

The gate runner 215 may include a conductive material. For example, the gate runner 215 may include the same material as the gate pad 211, but is not limited thereto. The gate runner 215 may be formed as a single layer or multi-layer.

In one or more embodiments, contact portions CT1, CT2, and CT3 may be located in the region where the gate runner 215 and the gate frame 160 are in contact with each other.

Referring to FIG. 2, the first contact portion CT1 may only overlap in the first direction D1 with four unit cells sequentially located along the second direction D2 from the first portion 161 among the entire unit cells UC arranged in the first active region AR1. In one or more embodiments, the remaining four unit cells UC that do not overlap with the first contact portion CT1 in the first direction D1 among the entire unit cells UC arranged in the first active region AR1 may overlap with the second contact portion CT2 in the first direction D1. In one or more embodiments, the number of the unit cells UC overlapping with the first contact portion CT1 in the first direction D1, and the number of the unit cells UC overlapping with the second contact portion CT2 in the first direction D1 may be similar. For example, the number of the unit cells UC overlapping with the first contact portion CT1 in the first direction D1 may be the same or substantially the same as the number of the unit cells UC overlapping with the second contact portion CT2 in the first direction D1.

In one or more embodiments, a first distance (e.g., distance from p1 to p2 in FIG. 2) from the gate pad 211 to the first contact portion CT1 in a direction in which the first gate runner 215a extends may be similar to a second distance (e.g., distance from p1 to p3 in FIG. 2) from the gate pad 211 to the second contact portion CT2 in a direction in which the second gate runner 215b extends. For example, the first distance and the second distance may be the same or substantially the same. In one or more embodiments, the first distance and the second distance may be distances measured from p1 to p2 and from p1 to p3, respectively, measured along the direction in which the gate runners 215a and 215b extend.

A starting point p1 for calculating a distance from the gate pad 211 to the first contact portion CT1 or the second contact portion CT2 may be set in various ways, in consideration of an actual portion of the metal wire in contact with the gate pad 211 for transfer of the gate signal. For example, when the gate pad 211 is a rectangular shape, as shown in FIG. 2, a point where diagonal lines of the rectangle cross each other may be set as the starting point. For example, the starting point p1 may be a center of the gate pad 211. The starting point p1 may be a point where the first gate runner 215a, the second gate runner 215b and the third gate runner 215c meet (or intersect).

In one or more examples, end points p2 and p3 for calculating the distance from the gate pad 211 to the first contact portion CT1 or the second contact portion CT2 may be set as a closest point from one side of the first portion 161 of the gate frame 160, facing the second direction D2, among an entire region of the first contact portion CT1 or the second contact portion CT2. End points p2 and p3 may be located on closest edges of the second contact portion CT2 and third contact portion CT1 to the gate pad 211, based on the path of the first gate runner 215a and second gate runner 215b.

Referring to FIG. 2, the third contact portion CT3 may only overlap in the first direction D1 with four unit cells sequentially located along the second direction D2 from the first portion 161 among the entire unit cells UC arranged in the second active region AR2. In one or more embodiments, the remaining four unit cells UC that do not overlap with the third contact portion CT3 in the first direction D1 among the entire unit cells UC arranged in the second active region AR2 may overlap with the second contact portion CT2 in the first direction D1. In one or more embodiments, the number of the unit cells UC overlapping with the third contact portion CT3 in the first direction D1, and the number of the unit cells UC overlapping with the second contact portion CT2 in the first direction D1 may be the same or similar.

In one or more embodiments, a third distance (distance from p1 to p4 in FIG. 2) from the gate pad 211 to the third contact portion CT3 in a direction in which the third gate runner 215c extends may be similar to the first distance (distance from p1 to p2 in FIG. 2) from the gate pad 211 to the first contact portion CT1 in a direction in which the first gate runner 215a extends. For example, the third distance and the first distance may be the same or substantially the same. In one or more embodiments, the first distance and the third distance may be distances measured from p1 to p2 and from p1 to p4, respectively, measured along the direction in which the gate runners 215a and 215c extend.

In one or more examples, the method of setting the starting point and the end point for calculating a distance from the gate pad 211 to the third contact portion CT3 or the second contact portion CT2 may be the same as the starting point and end point for calculating the distance from the gate pad 211 to the first contact portion CT1 or the second contact portion CT2 described above, and detailed description thereon will be omitted.

In one or more embodiments, the first distance (distance from p1 to p2 in FIG. 2), the second distance (distance from p1 to p3 in FIG. 2) and the third distance (distance from p1 to p4 in FIG. 2) may be the same or substantially the same. A detailed description thereon may be omitted.

In one or more examples, when the gate runner 215 and the gate frame 160 are in contact with each other over the entire overlapping region, a time difference for respective unit cells UC to be completely turned on or off may be lengthened. For example, the time difference in turning on and turning off between the unit cell UC located most adjacent to the first portion 161 and the unit cell UC located farthest therefrom may be excessively long. That is, there may be a relatively large difference in the time for turning on the unit cell that is closest to the first portion 161 and the unit cell that is farthest from the first portion 161.

A semiconductor device according to one or more embodiments may be configured such that contact portions CT1, CT2, and CT3 may be formed in only a partial region where the gate runner 215 and the gate frame 160 overlap with each other, and the lengths from the gate pad 211 (e.g. from a center of the gate pad 211 ) to respective contact portions CT1, CT2, and CT3 may be the same. Based on these features, the time difference for the respective unit cells UC to be completely turned on or off may be advantageously reduced, and accordingly, the reliability of the semiconductor device may be significantly improved.

In one or more embodiments, a distance from one side facing the second direction D2 of the first portion 161 to the first contact portion CT1 may be shorter than a distance b from one side facing the second direction D2 of the first portion 161 to the second contact portion CT2.

In one or more embodiments, a distance c from one side facing the second direction D2 of the first portion 161 to the third contact portion CT3 may be shorter than the distance b from one side facing the second direction D2 of the first portion 161 to the second contact portion CT2.

In one or more embodiments, the distance a from one side facing the second direction D2 of the first portion 161 to the first contact portion CT1 may be the same or substantially the same as the distance c from one side facing the second direction D2 of the first portion 161 to the third contact portion CT3.

In one or more embodiments, the distance a from one side facing the second direction D2 of the first portion 161 to the first contact portion CT1 may be shorter than a distance from the gate pad 211 to the second contact portion CT2 along a direction in which the second gate runner 215b extends.

In one or more embodiments, widths of the first contact portion CT1, the second contact portion CT2, and the third contact portion CT3 along the second direction D2 is not limited to the embodiment shown in FIG. 2. For example, the width of the first contact portion CT1 along the second direction D2 may be designed to be wider or narrower than what is shown in FIG. 2, within a range for overlapping with four unit cells sequentially located along the second direction D2 from the first portion 161 among the entire unit cells UC arranged in the first active region AR1.

For example, a width of the third contact portion CT3 along the second direction D2 may be designed to be wider or narrower than what is shown in FIG, within a range for overlapping with four unit cells sequentially located along the second direction D2 from the first portion 161 among the entire unit cells UC arranged in the second active region AR2. 2.

For example, a width of the second contact portion CT2 along the second direction D2 may be wider or narrower than what is shown in FIG. 2, within a range for overlapping with remaining four unit cells UC that do not overlap with the first contact portion CT1 and the third contact portion CT3 in the first direction D1 among the entire unit cells UC arranged in the first active region AR1 and the second active region AR2.

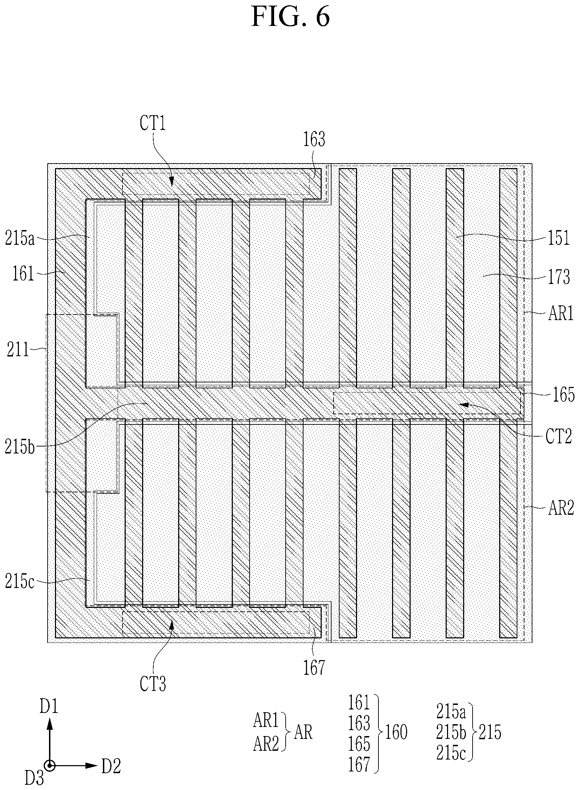

FIG. 6 is a top plan view showing a semiconductor device according to one or more embodiments. The semiconductor device shown in FIG. 6 is substantially similar to the semiconductor device described with reference to FIG. 1 to FIG. 5, and hereinafter, differences from the above will be embodiments will be focused in the description below.

In more detail, a semiconductor device according to one or more embodiments may be different from the previous embodiments, in lengths by which the gate runners 215a, 215b, and 215c and the gate frame 160 extend.

Referring to FIG. 6, the length by which the first gate runner 215a and the second portion 163 extends in the second direction D2 may be shorter than the length by which the second gate runner 215b and the third portion 165 extend. For example, the first gate runner 215a and the second portion 163 may extend only to a periphery of a region where the first contact portion CT1 is formed.

In one or more embodiments, the unit cells UC overlapping with the second contact portion CT2 in the first direction D1 among the unit cells UC located in the first active region AR1 may not be connected to the second portion 163. Accordingly, the unit cells UC overlapping with the second contact portion CT2 in the first direction D1 may not receive gate signals from the first gate runner 215a.

Referring to FIG. 6, the length by which the third gate runner 215c and the fourth portion 167 extends in the second direction D2 may be shorter than the length by which the second gate runner 215b and the third portion 165 extend. For example, the third gate runner 215c and the fourth portion 167 may extend only to a periphery of a region where the third contact portion CT3 is formed.

In one or more embodiments, the unit cells UC overlapping with the second contact portion CT2 in the first direction D1 among the unit cells UC located in the second active region AR2 may not be connected to the fourth portion 167. Accordingly, the unit cells UC overlapping with the second contact portion CT2 in the first direction D1 may not receive gate signals from the third gate runner 215c.

In one or more embodiments, the unit cells UC overlapping with the second contact portion CT2 in the first direction D1 may extend longer in the first direction D1, in comparison with the embodiment shown in FIG. 2. For instance, the unit cells UC overlapping with the second contact portion CT2 in the first direction D1 may extend longer in the first direction D1 than the other unit cells UC (e.g. the unit cells overlapping the first contact portion CT1 and the third contact portion CT3 in the first direction D1). Referring to FIG. 6, the unit cells UC overlapping with the second contact portion CT2 in the first direction D1 may extend to have first ends adjacent to the one edge of the peripheral area PERI (see FIG. 2). The first ends may overlap the second portion 163 or the fourth portion 167 in the second direction D2. The unit cells UC overlapping with the second contact portion CT2 in the first direction D1 may be spaced apart from an end portion of the second portion 163, or an end portion of the fourth portion 167 in the second direction D2.

According to one or more embodiments, the influence of the signal provided from the first gate runner 215a or the third gate runner 215c on the unit cells UC overlapping with the second contact portion CT2 in the first direction D1 may be removed. According to one or more embodiments, in comparison with the embodiment described with reference to FIG. 1 to FIG. 5, the area of the active region AR may become wider.

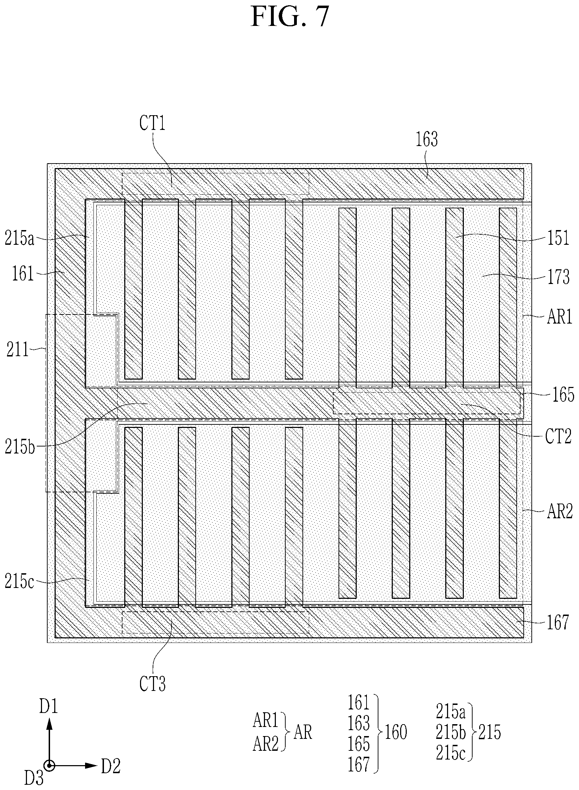

FIG. 7 is a top plan view showing a semiconductor device according to one or more embodiments.

The semiconductor device shown in FIG. 7 is substantially similar the above embodiments, and hereinafter, differences from the above will be embodiments will be focused in the description below.

In more detail, a semiconductor device according to one or more embodiments may be different from the previous embodiments, in the connection relationship of the unit cells UC.

Referring to FIG. 7, the unit cells UC (e.g. in the first active region AR1) overlapping with the first contact portion CT1 in the first direction D1 may be connected to the second portion 163, and may not be connected to the third portion 165. For example, the unit cells UC overlapping with the first contact portion CT1 in the first direction D1 may be spaced apart from the third portion 165 in the first direction D1. First ends of the unit cells UC overlapping with the first contact portion CT1 in the first direction D1 may be connected to the second portion 163.

Referring to FIG. 7, the unit cells UC overlapping with the second contact portion CT2 in the first direction D1 may be connected to the third portion 165, and may not be connected to the second portion 163 and the fourth portion 167. For example, the unit cells UC overlapping with the second contact portion CT2 in the first direction D1 may be spaced apart from the second portion 163 and the fourth portion 167 in the first direction D1. Second ends of the unit cells UC overlapping with the second contact portion CT2 in the first direction D1 may be connected to the third portion 165.

Referring to FIG. 7, the unit cells UC (e.g. in the second active region AR2) overlapping with the third contact portion CT3 in the first direction D1 may be connected to the fourth portion 167, and may not be connected to the third portion 165. For example, the unit cells UC overlapping with the third contact portion CT3 in the first direction D1 may be spaced apart from the third portion 165 in the first direction D1. The first ends of the unit cells UC overlapping with the third contact portion CT3 in the first direction D1 may be connected to the fourth portion 167.

According to one or more embodiments, the influence of the signal provided from the second gate runner 215b on the unit cells UC overlapping with the first contact portion CT1 in the first direction D1 may be removed. According to one or more embodiments, the influence of the unit cells UC overlapping the first contact portion CT1 in the first direction (D1) on the signal provided from the second gate runner 215b can be eliminated.

According to one or more embodiments, the influence of the signal provided from the first gate runner 215a or the third gate runner 215c on the unit cells UC overlapping with the second contact portion CT2 in the first direction D1 may be removed.

According to one or more embodiments, the influence of the signal provided from the second gate runner 215b on the unit cells UC overlapping with the third contact portion CT3 in the first direction D1 may be removed.

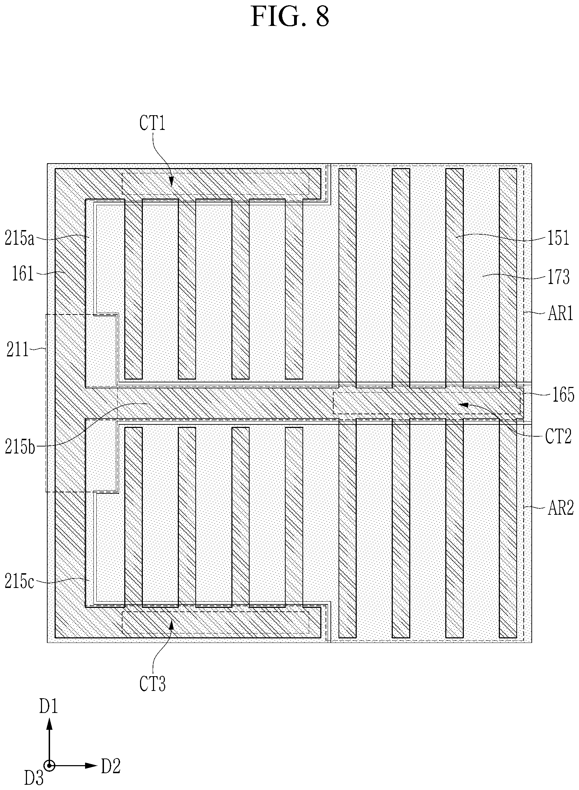

FIG. 8 is a top plan view showing a semiconductor device according to one or more embodiments.

The semiconductor device shown in FIG. 8 is substantially similar the above embodiments, and hereinafter, differences from the above will be embodiments will be focused in the description below.

In more detail, a semiconductor device according to one or more embodiments may be different from the previous embodiments, in the length by which the gate runners 215a, 215b, and 215c and the gate frame 160 extend and the connection relationship of the unit cells UC.

The semiconductor device shown in FIG. 8 may be different from the semiconductor device shown in FIG. 7, in the length by which the gate runners 215a, 215b, and 215c and the gate frame 160 extend.

Referring to FIG. 8, the length by which the first gate runner 215a and the second portion 163 extends in the second direction D2 may be shorter than the length by which the second gate runner 215b and the third portion 165 extend. For example, the first gate runner 215a and the first portion 161 may extend only to a region where the first contact portion CT1 is formed.

The length by which the third gate runner 215c and the fourth portion 167 extends in the second direction D2 may be shorter than the length by which the second gate runner 215b and the third portion 165 extend. For example, the third gate runner 215c and the fourth portion 167 may extend only to a region where the third contact portion CT3 is formed.

In one or more embodiments, the unit cells UC overlapping with the first contact portion CT1 in the first direction D1 may be connected only to the second portion 163, the unit cells UC overlapping with the second contact portion CT2 in the first direction D1 may be connected only to the third portion 165, and the unit cells UC overlapping with the third contact portion CT3 in the first direction D1 may be connected only to the fourth portion 167.

Referring to FIG. 8, the unit cells UC overlapping with the second contact portion CT2 in the first direction D1 may extend longer in the first direction D1, in comparison with the embodiment shown in FIG. 2. For instance, the unit cells UC overlapping with the second contact portion CT2 in the first direction D1 may extend longer in the first direction D1 than the other unit cells UC (e.g. the unit cells overlapping the first contact portion CT1 and the third contact portion CT3 in the first direction D1). The unit cells UC overlapping with the second contact portion CT2 in the first direction D1 may be spaced apart from the second portion 163, or the fourth portion 167 in the second direction D2.

According to one or more embodiments, in comparison with the semiconductor device described with reference to FIG. 7, the area of the active region AR may become wider.

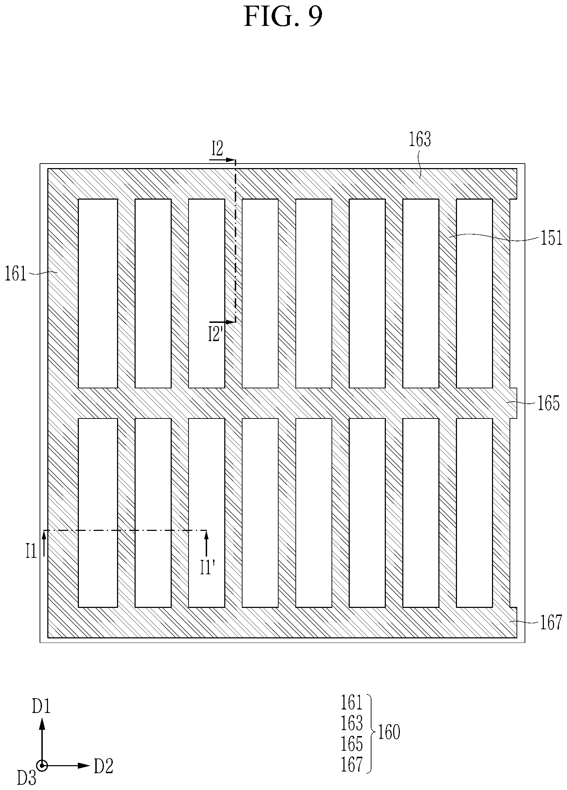

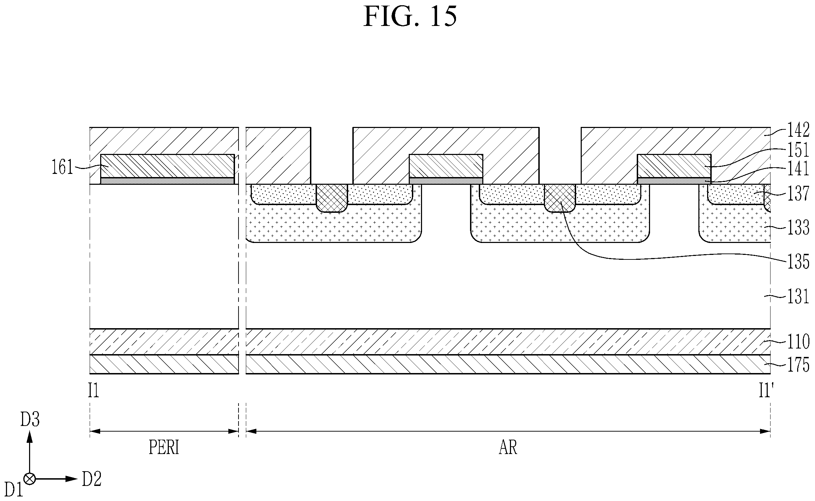

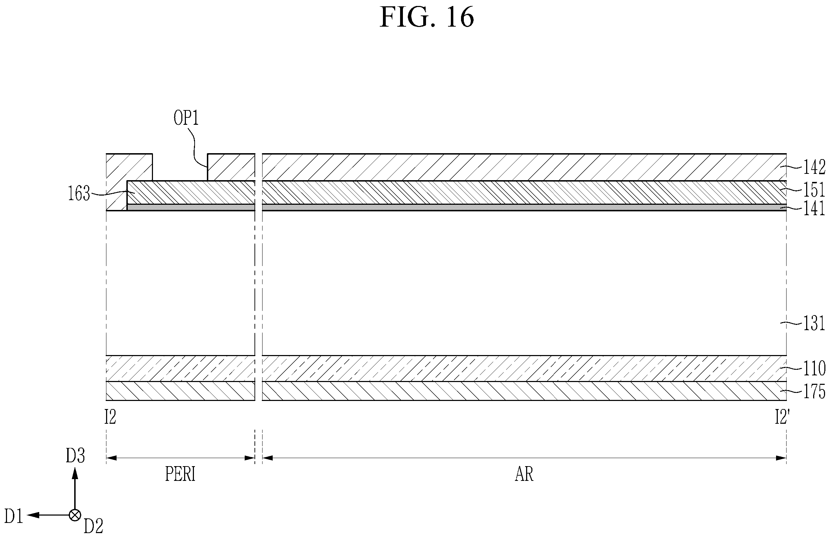

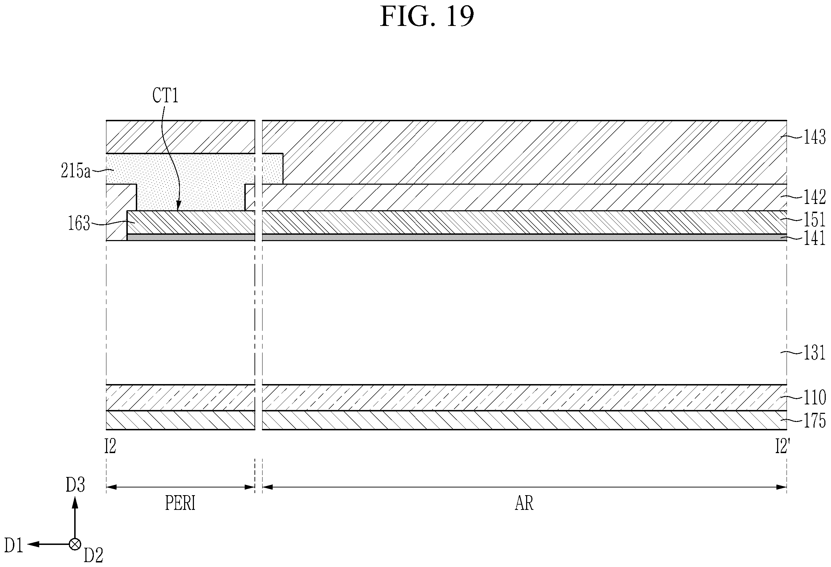

FIG. 9 to FIG. 19 are process cross-sectional views sequentially representing a manufacturing method of a semiconductor device according to one or more embodiments.

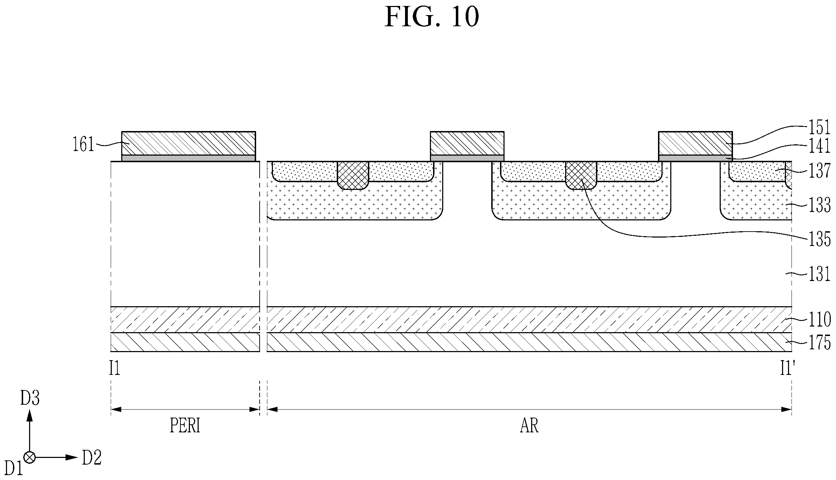

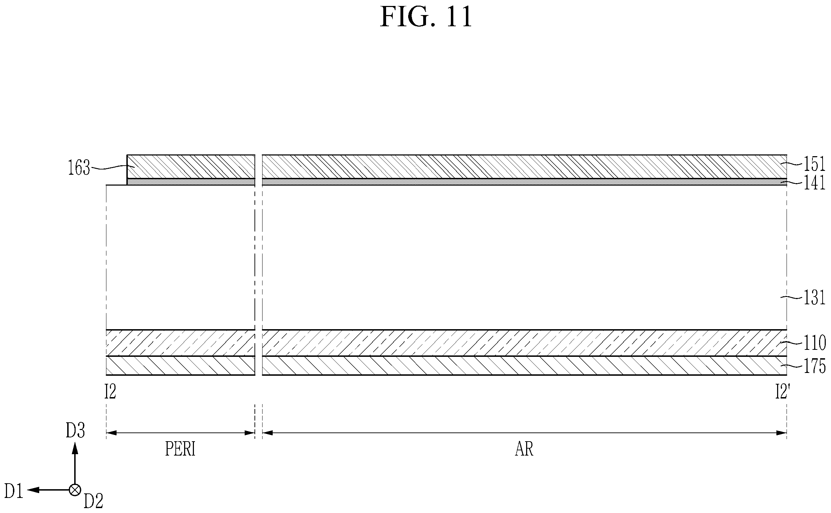

FIG. 9, FIG. 14, and FIG. 17 are top plan views for explaining a manufacturing method of a semiconductor device according to one or more embodiments. FIG. 10, FIG. 12, FIG. 15, and FIG. 18 are cross-sectional views corresponding to a region taken along line l1-l1' of FIG. 2, for explaining a manufacturing method of a semiconductor device according to one or more embodiments. FIG. 11, FIG. 13, FIG. 16, and FIG. 19 are cross-sectional views corresponding to a region taken along line l2-l2' of FIG. 2, for explaining a manufacturing method of a semiconductor device according to one or more embodiments.

As shown in FIG. 9 to FIG. 11, the second conductivity type doping well region 133, the first conductivity type doping layer 137 and the second conductivity type doping layer 135 may be sequentially formed on the upper portion of the first conductivity type semiconductor layer 131 located on the substrate 110.

The substrate 110 may be a semiconductor substrate including SiC. For example, the substrate 110 may be formed in 4H SiC substrate. The substrate 110 may be doped to n-type at a high concentration. The substrate 110 may include the first surface and the second surface facing each other. The first surface of the substrate 110 may be an upper surface, and the second surface of the substrate 110 may be a lower surface.

The first conductivity type semiconductor layer 131 may be formed on the first surface of the substrate 110, i.e., on the upper surface by using an epitaxial growth method. The first conductivity type semiconductor layer 131 may be formed entirely over the active region AR and the peripheral area PERI. The first conductivity type semiconductor layer 131 may be formed directly on the substrate 110, and alternatively, after forming another predetermined layer on the substrate 110, the first conductivity type semiconductor layer 131 may be formed thereon. The first conductivity type semiconductor layer 131 may include SiC. For example, the first conductivity type semiconductor layer 131 may include 4H SiC. The first conductivity type semiconductor layer 131 may be doped to n-type at a low concentration. The doping type of the first conductivity type semiconductor layer 131 may be the same as the doping type of the substrate 110. The doping material of the first conductivity type semiconductor layer 131 may be the same as the doping material of the substrate 110, and may be different therefrom. The doping concentration of the first conductivity type semiconductor layer 131 may be lower than the doping concentration of the substrate 110.

Subsequently, the second conductivity type doping well region 133 may be formed on an upper region of the first conductivity type semiconductor layer 131. In one or more embodiments, the second conductivity type doping well region 133 may be formed only in the active region AR. However, it is not limited thereto, and the second conductivity type doping well region 133 may also be formed in the peripheral area PERI. For example, the second conductivity type doping well region 133 may also be formed in the region that overlaps with the gate frame 160 in the third direction D3.

The second conductivity type doping well region 133 may be formed by an ion implantation process (IIP). First, by using the photolithography process, a region where the second conductivity type doping well region 133 is formed may be defined on the first conductivity type semiconductor layer 131. Thereafter, second conductive impurities ions may be implanted into that region. The second conductivity type doping well region 133 may have a predetermined depth. At this time, the depth of the second conductivity type doping well region 133 may be determined by the number of the implanted ions and/or the speed by which ions are accelerated.

In one or more embodiments, the second conductivity type doping well region 133 may include SiC. For example, the second conductivity type doping well region 133 may include 4H SiC. The second conductivity type doping well region 133 may be doped to p-type. The second conductivity type doping well region 133 may be doped to p-type at a low concentration. For example, doping concentration of the second conductivity type doping well region 133 may be about 1*10¹⁷cm⁻³ or more and about 1*10¹⁹cm⁻³ or less. The material, doping type, doping concentration, etc. of the second conductivity type doping well region 133 is not limited thereto, and may be changed in various ways.

Subsequently, the first conductivity type doping layer 137 may be formed by implanting ions into the second conductivity type doping well region 133. The first conductivity type doping layer 137 may be formed within the second conductivity type doping well region 133 through an ion implantation process. The first conductivity type doping layer 137 may be formed in at least a partial region of the second conductivity type doping well region 133. For example, the first conductivity type doping layer 137 may be formed to a predetermined depth from the upper surface of the second conductivity type doping well region 133.

The first conductivity type doping layer 137 may include SiC. For example, the first conductivity type doping layer 137 may include 4H SiC. The first conductivity type doping layer 137 may be doped to n-type at a high concentration. The doping type of the first conductivity type doping layer 137 may be different from the doping type of the second conductivity type doping well region 133. The doping type of the first conductivity type doping layer 137 may be the same as the doping type of the substrate 110 and the first conductivity type semiconductor layer 131. The doping concentration of the first conductivity type doping layer 137 may be about 1*10¹³cm⁻³ or more and about 5*10²⁰cm⁻³ or less. The material, doping type, doping concentration, etc. of the first conductivity type doping layer 137 is not limited thereto, and may be changed in various ways.

Subsequently, the second conductivity type doping layer 135 may be further formed by implanting ions into the second conductivity type doping well region 133 and the first conductivity type doping layer 137. In one or more embodiments, the second conductivity type doping layer 135 may be formed only in the active region AR. However, it is not limited thereto, and the second conductivity type doping layer 135 may also be formed in the peripheral area PERI. For example, the second conductivity type doping layer 135 may also be formed in the region that overlaps with the gate frame 160 in the third direction D3.

First, by using the photolithography process, a region where the second conductivity type doping layer 135 is formed may be defined on the first conductivity type doping layer 137. The region where the second conductivity type doping layer 135 is formed may have a smaller width than the second conductivity type doping well region 133 or the first conductivity type doping layer 137. In one or more embodiments, a depth at which the second conductivity type doping layer 135 is formed may be deeper than the depth of the first conductivity type doping layer 137. The second conductivity type doping layer 135 may penetrate the first conductivity type doping layer 137 in the thickness direction. At least a partial region of the both side surfaces of the second conductivity type doping layer 135 may be surrounded by the first conductivity type doping layer 137.

The second conductivity type doping layer 135 may include SiC. For example, the second conductivity type doping layer 135 may include 4H SiC. The second conductivity type doping layer 135 may be doped to p-type at a high concentration. The doping type of the second conductivity type doping layer 135 may be the same as the doping type of the second conductivity type doping well region 133. The doping material of the second conductivity type doping layer 135 may be the same as the doping material of the second conductivity type doping well region 133, and may be different therefrom. The doping concentration of the second conductivity type doping layer 135 may be higher than the doping concentration of the second conductivity type doping well region 133.

Subsequently, the gate insulating layer 141 may be formed on the first conductivity type semiconductor layer 131, and the gate electrodes 151 and the gate frame 160 may be formed on the gate insulating layer 141. In one or more embodiments, the gate insulating layer 141 may be formed not only in the active region AR but also in the peripheral area PERI. The gate insulating layer 141, the gate electrode 151, and the gate frame 160 may also be located partially on the second conductivity type doping well region 133 and the first conductivity type doping layer 137. First, a gate insulating material layer may be formed on an entire region of the upper surface of the first conductivity type semiconductor layer 131, the second conductivity type doping well region 133, the first conductivity type doping layer 137, and the second conductivity type doping layer 135. The gate insulating material layer may be formed by a high-temperature oxidation process. A gate material layer may be formed by depositing polysilicon on the gate insulating material layer. Thereafter, the gate insulating layer 141, the gate electrodes 151, and the gate frame 160 may be formed by etching a portion of the gate insulating material layer and the gate material layer. At this time, the upper surface of the first conductivity type semiconductor layer 131, the second conductivity type doping layer 135, and the first conductivity type doping layer 137 may be partially exposed.

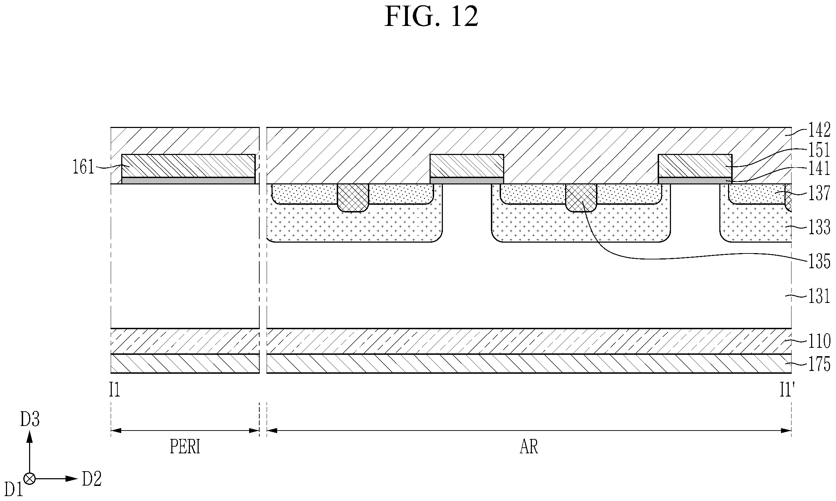

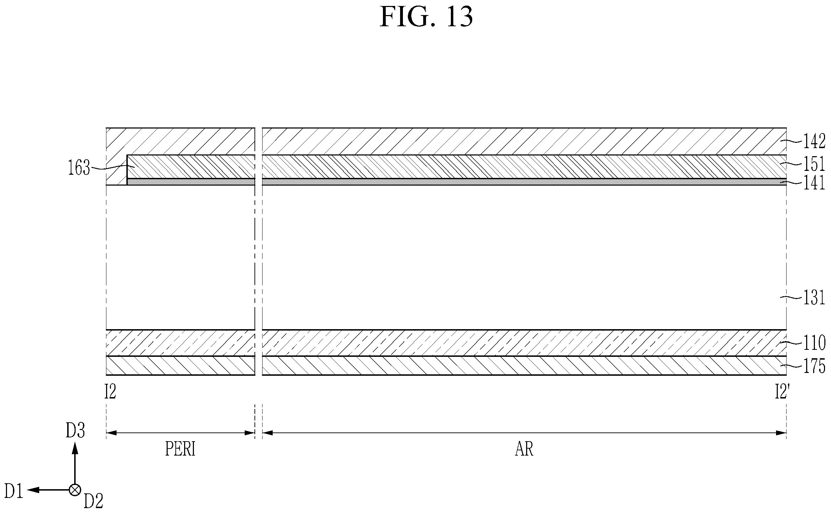

As shown in FIG. 12 and FIG. 13, the first interlayer insulating layer 142 covering the gate electrode 151, the gate frame 160 and the gate insulating layer 141 may be formed. The first interlayer insulating layer 142 may be formed entirely over the active region AR and the peripheral area PERI. The first interlayer insulating layer 142 may also cover the upper surface of the second conductivity type doping layer 135 and a partial region of the upper surface of the first conductivity type doping layer 137. The first interlayer insulating layer 142 may include silicon oxide (SiO₂). However, it is not limited thereto, and material of the first interlayer insulating layer 142 may be changed in various ways. As another example, the first interlayer insulating layer 142 may include silicon nitride (SiN_{X}), silicon oxynitride (SiON), silicon carbide (SiC), silicon carbon nitride (SiCN) or a combination thereof. However, formation method and material, or the like, of the first interlayer insulating layer 142 is not limited thereto, and may be changed in various ways.

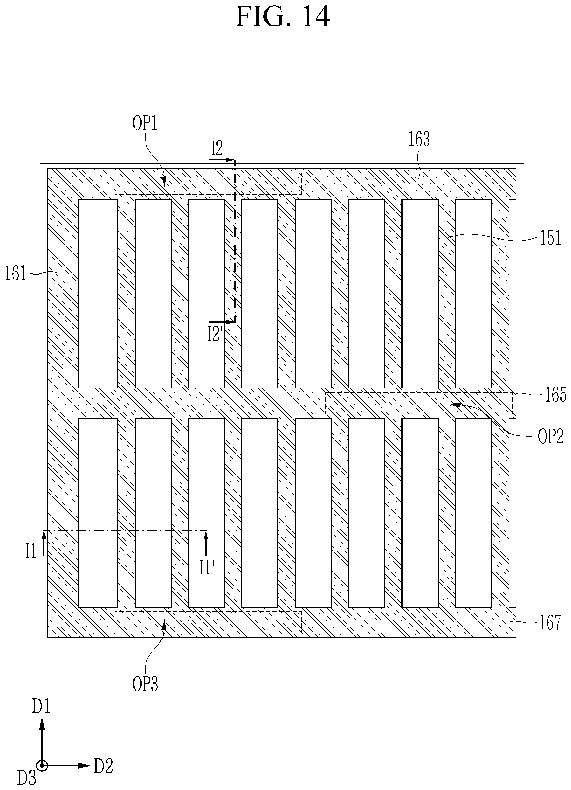

As shown in FIG. 14 to FIG. 16, a partial region of the first interlayer insulating layer 142 may be etched (e.g. by using a photo and etching process).

In the active region AR, by etching a partial region of the first interlayer insulating layer 142, a partial region of the upper surface of the second conductivity type doping layer 135 may be exposed. For example, among an entire region of the first interlayer insulating layer 142, at least a portion of a region overlapping with the second conductivity type doping layer 135 in the third direction D3 may be etched.

In the peripheral area PERI, by etching a partial region of the first interlayer insulating layer 142, a plurality of openings OP1, OP2, and OP3 may be formed. In one or more embodiments, a first opening OP1, a second opening OP2, and a third opening OP3 may be formed in a partial region of the second portion 163, the third portion 165, and the fourth portion 167 of the gate frame 160, respectively. In one or more embodiments, the first opening OP1, the second opening OP2, and the third opening OP3 may correspond to the first contact portion CT1, the second contact portion CT2, and the third contact portion CT3 described with reference to FIG. 1 to FIG. 5, respectively.

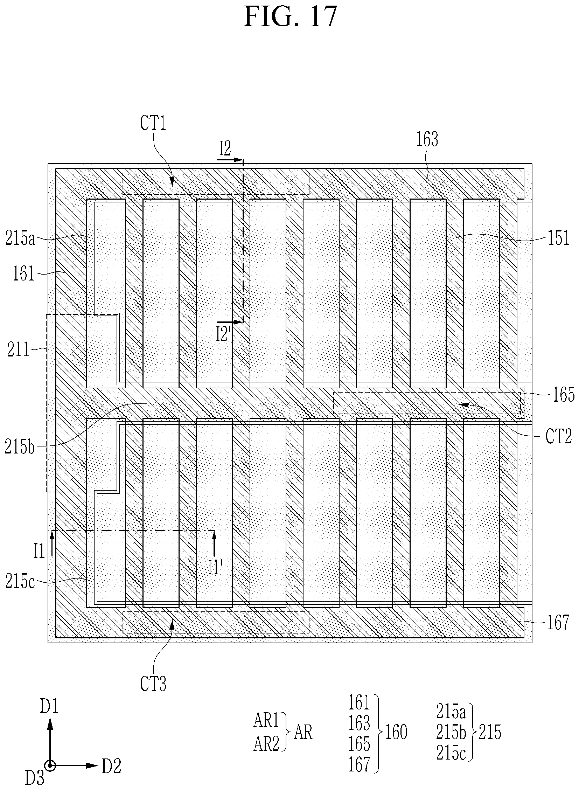

As shown in FIG. 17 to FIG. 19, the gate runner 215, the gate pad 211, the source electrode 173 and the drain electrode 175 may be formed.

In one or more embodiments, the source electrode 173, the gate runner 215, and the gate pad 211 may be formed in the same process step. First, a metallic material may be formed entirely on the first surface of the substrate 110, and then a portion of the region may be etched (e.g. by a photo and etching process), thereby forming the source electrode 173, the gate runner 215, and the gate pad 211 together.

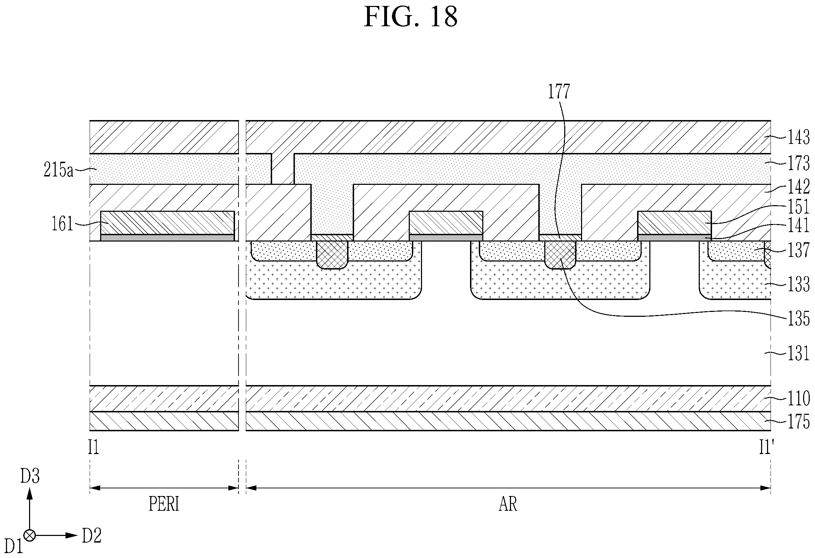

The source electrode 173 may be formed in the active region AR. The source electrode 173 may be formed on at least a partial region of the upper surface of the second conductivity type doping layer 135 externally exposed, in the previous step. Referring to FIG. 18, the silicide layer 177 may be formed between the source electrode 173 and the second conductivity type doping layer 135. In one or more embodiments, the silicide layer 177 may be formed by depositing the source electrode 173 on the second conductivity type doping layer 135, and then performing the annealing process, but is not limited thereto. The silicide layer 177 may include a metal silicide material. For example, the silicide layer 177 may include tungsten silicide (WSi), titanium silicide (TiSi), cobalt silicide (CoSi), nickel silicide (NiSi), or a combination thereof.

The gate runner 215 may be formed in the peripheral area PERI. In one or more embodiments, the gate runner 215 may also be formed in a partial region of the active region AR. As the metallic material is filled in the openings OP1, OP2, and OP3 formed in the previous step, contact portions CT1, CT2, and CT3 for electrically connecting the gate runner 215 and the gate frame 160 may be formed. Although not clearly shown in FIG. 17 to FIG. 19, the silicide layer may also be formed in the interface between the gate runner 215 and the gate frame 160.

The gate pad 211 may be formed in the peripheral area PERI. The gate pad 211 may also be formed in a partial region of the active region AR. In one or more embodiments, the gate pad 211, the gate runner 215, the source electrode 173 may include the same material. In one or more embodiments, the gate pad 211 and the gate runner 215 may be integrally formed.

Subsequently, the second interlayer insulating layer 143 covering the gate pad 211, the gate runner 215, the source electrode 173 may be formed. The second interlayer insulating layer 143 may be formed entirely over the active region AR and the peripheral area PERI. By the second interlayer insulating layer 143, the gate pad 211 and the source electrode 173, and the gate runner 215 and the source electrode 173 may be electrically separated. The second interlayer insulating layer 143 may include an insulating material. For example, the second interlayer insulating layer 143 may be composed of a polymer layer such as polyimide (PI), but is not limited thereto.

Subsequently, the drain electrode 175 may be formed on the second surface of the substrate 110. The drain electrode 175 may entirely cover the second surface of the substrate 110. However, it is not limited thereto, and the drain electrode 175 may cover only a partial region of the second surface of the substrate 110. The drain electrode 175 may include a conductive material. For example, the drain electrode 175 may include a metal, a metal alloy, a conductive metal nitride, a metal silicide, a doped semiconductor material, a conductive metal oxide, a conductive metal nitride oxide, or any other suitable material known to one of ordinary skill in the art. The drain electrode 175 may be formed of the same material as the source electrode 173, and may be formed of a different material therefrom. The drain electrode 175 may be formed as a single layer or multi-layer.

While the embodiment of the present disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

Embodiments are set out in the following clauses:
Clause 1. A semiconductor device, comprising:
   a substrate comprising (i) a first active region comprising a plurality of unit cells, and (ii) a peripheral area surrounding at least a portion of the first active region;
   a gate frame comprising (i) a first portion in the peripheral area and extending along a first direction, (ii) a second portion extending from one side of the first portion along a second direction crossing the first direction and connected to first end of at least a portion among the plurality of unit cells, and (iii) a third portion extending from the first side along the second direction and connected to second end of at least a portion among the plurality of unit cells;
   a gate pad at a point where the first portion of the gate frame and the third portion of the gate frame are connected;
   a first gate runner on the first portion of the gate frame and the second portion of the gate frame; and
   a second gate runner on the third portion of the gate frame, and extending from a first side of the gate pad along the second direction,
   wherein the first gate runner and the second portion of the gate frame are connected through a first contact portion, and the second gate runner and the third portion of the gate frame are connected through a second contact portion, and
   wherein a first distance from the one side of the first portion of the gate frame to the first contact portion is shorter than a second distance from a center of the gate pad to the second contact portion.
Clause 2. The semiconductor device of Clause 1, wherein a third distance from the gate pad to the first contact portion along a direction in which the first gate runner extends and a fourth distance from the gate pad to the second contact portion along a direction in which the second gate runner extends are the same.
Clause 3. The semiconductor device of Clause 1 or Clause 2, wherein the first contact portion and the second contact portion are non-overlapping in the first direction.
Clause 4. A semiconductor device, comprising:
   a substrate comprising (i) a plurality of active regions spaced apart in a first direction and comprising a plurality of unit cells, and (ii) a peripheral area surrounding at least a portion of the plurality of active regions;
   a gate frame comprising (i) a first portion located in the peripheral area and extending along the first direction, (ii) a third portion extending from one side between a first end and a second end of the first portion along a second direction crossing the first direction, and (iii) a second portion and a fourth portion extending along the second direction and spaced apart from each other in the first direction with the third portion between the second portion and the fourth portion;
   a gate pad on a central portion between the first end and the second end of the first portion of the gate frame;
   a first gate runner on a portion of the first portion of the gate frame and the second portion of the gate frame;
   a second gate runner on the third portion of the gate frame; and
   a third gate runner located on another portion of the first portion of the gate frame, and the fourth portion of the gate frame,
   wherein the first gate runner and the second portion of the gate frame are connected through a first contact portion, and the second gate runner and the third portion of the gate frame are connected through a second contact portion, and the third gate runner and the fourth portion are connected through a third contact portion, and
   wherein a first distance from the gate pad to the first contact portion along a direction in which the first gate runner extends and a second distance from the gate pad to the third contact portion along a direction in which the third gate runner extends are the same as a third distance from the gate pad to the second contact portion along a direction in which the second gate runner extends.
Clause 5. The semiconductor device of Clause 4, wherein the second contact portion, the first contact portion, and the third contact portion are non-overlapping in the first direction.

## Claims

1. A semiconductor device, comprising:
a substrate comprising (i) a first active region comprising a plurality of unit cells, and (ii) a peripheral area surrounding at least a portion of the first active region;
a gate frame comprising (i) a first portion in a wiring region and extending along a first direction, (ii) a second portion extending from one side of the first portion along a second direction crossing the first direction and connected to a first end of at least a portion among the plurality of unit cells, and (iii) a third portion extending from the one side along the second direction and connected to a second end of at least a portion among the plurality of unit cells;
a first gate runner on the first portion of the gate frame and the second portion of the gate frame; and
a second gate runner on the third portion,
wherein a first distance between the first portion of the gate frame and a first contact portion where the first gate runner and the second portion of the gate frame are connected is shorter than a second distance between the first portion of the gate frame and a second contact portion where the second gate runner and the third portion of the gate frame are connected.

2. The semiconductor device of claim 1, further comprising:
a gate pad on a point where the first portion of the gate frame and the third portion of the gate frame are connected,
wherein the first gate runner extends from a first side surface of the gate pad facing the first direction, and
wherein the second gate runner extends from a second side surface of the gate pad facing the second direction.

3. The semiconductor device of claim 2, wherein a third distance from the gate pad to the first contact portion along a direction in which the first gate runner extends and a fourth distance from the gate pad to the second contact portion along a direction in which the second gate runner extends are the same.

4. The semiconductor device of claim 2 or claim 3, wherein the gate pad is configured to cover a portion of the first active region.

5. The semiconductor device of any preceding claim, wherein the first contact portion and the second contact portion are non-overlapping in the first direction.

6. The semiconductor device of any preceding claim, wherein, a plurality of first unit cells overlapping with the first contact portion in the first direction, and a plurality of second unit cells overlapping with the second contact portion in the first direction are in the first active region.

7. The semiconductor device of claim 6, wherein a number of first unit cells in the plurality of first unit cells and a number of second unit cells in the plurality of second unit cells are the same.

8. The semiconductor device of claim 6 or claim 7, wherein:
a length by which the plurality second unit cells extend in the first direction is longer than a length by which the plurality of first unit cells extend in the first direction; and
the plurality of second unit cells are spaced apart from the second portion in the second direction.

9. The semiconductor device of any of claims 6-8, wherein a length by which the second portion of the gate frame extends in the second direction is shorter than a length by which the third portion of the gate frame extends in the second direction.

10. The semiconductor device of any of claims 6-9, wherein the plurality of first unit cells are spaced apart from the third portion of the gate frame in the first direction, and a first end of each of the first unit cells is connected to the second portion.

11. The semiconductor device of any of claims 6-10, wherein:
the plurality of first unit cells are spaced apart from the third portion of the gate frame in the first direction, and each first end of the plurality of first unit cells is connected to the second portion of the gate frame; and
the plurality of second unit cells are spaced apart from the second portion of the gate frame in the first direction, and each second of the plurality of second unit cells are connected to the third portion of the gate frame.

12. The semiconductor device of any of claims 6-11, wherein each of the plurality of first unit cells and each of the plurality of second unit cells comprise:
a first conductivity type semiconductor layer located on a first surface of the substrate;
a second conductivity type doping well region located within the first conductivity type semiconductor layer;
a gate electrode located on the first conductivity type semiconductor layer;
a gate insulating layer located between the first conductivity type semiconductor layer and the gate electrode;
a source electrode located on the second conductivity type doping well region; and
a drain electrode located on a second surface facing the first surface of the substrate,
wherein the gate electrode extends in the first direction, and
wherein the gate electrode comprises a first end connected to the second portion of the gate frame and a second end connected to the third portion of the gate frame.

13. The semiconductor device of claim 12, further comprising:
a second conductivity type doping layer located in a first portion of the first conductivity type semiconductor layer, and overlapping with the source electrode in a thickness direction; and
a silicide layer located between the second conductivity type doping layer and the source electrode.

14. The semiconductor device of any preceding claim, further comprising:
a second active region spaced apart from the first active region along the first direction,
wherein the third portion of the gate frame is between the first active region and the second active region.

15. The semiconductor device of claim 14, wherein:
the gate frame further comprises a fourth portion extending from the one side of the first portion of the gate frame along the second direction, and spaced apart from the third portion of the gate frame in an opposite direction of the first direction;
the semiconductor device further comprises a third gate runner on the first portion of the gate frame and the fourth portion;
the third gate runner and the fourth portion of the gate frame are connected through a third contact portion; and
a third distance from the one side of the first portion of the gate frame to the third contact portion is shorter than a fourth distance from the one side of the first portion to the second contact portion.
